# EUROPÄISCHE PATENTANMELDUNG

(11) **EP 4 471 223 A1**
(43) Veröffentlichungstag der Anmeldung: **04.12.2024**
(21) Anmeldenummer: 24167205.4
(22) Anmeldetag: 28.03.2024
(51) Int. Cl.: E04D 13/00, G01M 3/16

(54) **BAUBAHN**

(30) Priorität: 30.05.2023 DE 102023002172
(71) Anmelder: EWALD DÖRKEN AG, 58313 Herdecke (DE)
(72) Erfinder: DAHMS, Severin, 44229 Dortmund (DE)
(74) Vertreter: Von Rohr Patentanwälte Partnerschaft mbB

(57) **Zusammenfassung**

Die Erfindung betrifft eine Baubahn (1), insbesondere zur Verwendung als Dachbahn, mit einer Trägerschicht (2), wobei auf der Außenseite (3) der Trägerschicht (2) eine Elektronikeinheit (4) aufweisend wenigstens einen Feuchtesensor (5) aufgebracht, insbesondere aufgedruckt, ist, wobei der Feuchtesensor (5) zur Feuchtemessung elektrisch mit einer Zuleitung (9) und einer Kontakt-Leiterbahn (31) verbunden ist. Erfindungsgemäß ist vorgesehen, dass zur Funktionsüberprüfung der elektrischen Kontaktierung des Feuchtesensors (5) eine Teststruktur (29) vorgesehen ist, die mit der Zuleitung (9) und der Kontakt-Leiterbahn (31) elektrisch verbunden ist.

## Beschreibung

Die vorliegende Erfindung betrifft eine Baubahn, die eine Trägerschicht aufweist. Insbesondere ist die Baubahn zur Verwendung als Dachbahn vorgesehen.

Die Baubahn kann im verlegten Zustand als Teil einer Gebäudehülle und/oder eines Baukörpers verwendet werden. Zudem kann die Baubahn an eine bereits im Dachbereich verlegte Gebäudehülle und/oder einen Baukörper angeordnet werden. Insbesondere wird die Baubahn in der Bauwirtschaft und/oder der Bautechnik verwendet. Darüber hinaus kann die Baubahn unterhalb, der Witterungsseite abgewandt, einer Begrünung und/oder eines Pflanzsubstrat und/oder einer Schüttung, insbesondere Kiesschüttung, und/oder an einer Dampfbremse angeordnet sein, insbesondere dem Innenraum eines Gebäudes zugewandt, und/oder als Fassadenbekleidung eingesetzt werden.

Des Weiteren kann die erfindungsgemäße Baubahn auch in Kombination mit einer Dachbahn, Dachfolie, Flachdachbahn, Fassadenbahn, Dampfbremse und/oder Unterdachbahn, insbesondere Unterdeck- bzw. und/oder Unterspannbahn, verwendet werden. Dabei kann die Baubahn an den vorgenannten Bahnen angeordnet und/oder fest mit diesen verbunden sein.

Bei Flachdächern ist es wesentlich, eine Wasser- und Winddichtigkeit unter der Abdichtungsebene und/oder der Hartbedachung und/oder der Fassadenverkleidung und/oder der Dachverkleidung sicherzustellen. Hierzu werden in der Regel wasser- und winddichte Bahnen und/oder eine solche Abdichtungsebene eingesetzt, die aus einer Mehrzahl von Streifen der Bahnen hergestellt wird. Zur Herstellung dieser Abdichtungsebene werden die Bahnen als Bahnenware als langgestreckte Streifen auf dem Dach und/oder entlang einer Fassade, insbesondere in Art als Bestandteil einer Gebäudehülle, befestigt. Die einzelnen Reihen der Baubahnstreifen werden miteinander, insbesondere über eine Klebeverbindung, verbunden oder miteinander verschweißt. Durch die Verbindung der einzelnen Bahnstreifen wird versucht, die notwendige Dichtigkeit der Abdichtungsebene zu gewährleisten.

Aufgrund von Verlegefehlern, aber auch bei Beschädigung der Abdichtungsebene kann es zu Undichtigkeiten kommen. Problematisch ist in diesem Zusammenhang, dass die Gebäudehülle und/oder die Fassadenverkleidung und/oder die Abdichtungsebene bzw. die einzelnen miteinander verbundenen Bahnstreifen im verlegten Zustand nicht ohne Weiteres sichtbar sind, da sie sich in der Regel zwischen der äußeren Verkleidung und einer weiteren Schicht, insbesondere eine Dämmplatte und/oder Kiesschüttungsschicht und/oder Innenverkleidungsplatten, insbesondere Decken-, Wand- und/oder Bodenverkleidung, befinden.

Dringt Feuchtigkeit über die Gebäudehülle und/oder die Abdichtungsebene, insbesondere bei einem Leck, ein, ist der Zeitraum, bis der Schaden erkannt wird, üblicherweise sehr lang. Eine vorhandene erhöhte Feuchtigkeit kann demzufolge unbemerkt Schäden verursachen, die zumeist dann bemerkt werden, wenn das Schadensbild, insbesondere im Inneren des Gebäudes, sichtbar wird. Ein aufgrund von erhöhter Feuchtigkeit hervorgerufener Schaden kann beispielsweise ein Wasserfleck an einer Wand im Innenraum eines Gebäudes sein. Ein derartiger Wasserfleck gibt dann Anlass zur Reparatur, wobei häufig weit mehr Bereiche geschädigt sind als nur die den Wasserfleck aufweisende Wand. Zur Schadensbehebung muss aufwendig die Gebäudehülle zumindest bereichsweise freigelegt werden, um das Leck zu finden. Dies ist üblicherweise mit einem sehr hohen Aufwand und einhergehend mit sehr hohen Kosten verbunden.

Grundsätzlich ist es in der Praxis bekannt, ein Überwachungssystem mit Feuchtesensoren für die Bedachung vorzusehen. Die im Stand der Technik bekannten Feuchtesensoren sind jedoch vergleichsweise fehleranfällig und insbesondere nicht für einen langfristigen Einsatz im Dachbereich geeignet. Darüber hinaus ist die Integration von im Stand der Technik bekannten Feuchtesensoren in eine Baubahn mit einem vergleichsweise großen Kostenaufwand verbunden.

Unter Berücksichtigung des Kosten-Nutzen-Verhältnisses wird in der Praxis meist von einer Überwachung der Feuchtigkeit in der Gebäudehülle und/oder der Unterbedachung abgesehen. Letztlich wird ein zu spätes Erkennen eines Wasserschadens in Anbetracht der Kosten für eine ständige bzw. dauerhafte Überwachung und insbesondere der Kosten für die Bereitstellung des Feuchtesensors an der Baubahn in Kauf genommen.

Darüber hinaus ist nachteilig, dass die montierten Baubahnen erst bei einem ersten Feuchtekontakt auf ihre Funktionsfähigkeit überprüfbar sind. Demnach muss sowohl beim Verlegen als auch werksseitig bei der Produktion ein hohes Augenmerk auf die korrekte Herstellung und Montage gelegt werden, um jedwede Schäden an der Baubahn zu vermeiden. Dies führt zu einem erhöhten Aufwand und auch der Gefahr, dass beschädigte Baubahnen eingebaut bzw. montiert werden, mit denen keine Feuchtemessung durchführbar ist, was jedoch erst im Schadenfall - und letztlich wenn es hierfür zu spät ist - feststellbar ist.

Aufgabe der vorliegenden Erfindung ist es nun, die vorgenannten Nachteile des Standes der Technik zu vermeiden oder aber zumindest im Wesentlichen zu reduzieren.

Die vorgenannte Aufgabe ist erfindungsgemäß durch eine Baubahn nach Anspruch 1 gelöst.

Die erfindungsgemäße Baubahn weist eine Trägerschicht auf, wobei auf die Außenseite der Trägerschicht eine wenigstens einen Feuchtesensor aufweisende Elektronikeinheit aufgebracht, bevorzugt aufgedruckt, ist.

Der Feuchtesensor ist zur Feuchtemessung elektrisch mit einer Zuleitung und einer Kontakt-Leiterbahn verbunden. Die Zuleitung und die Kontakt-Leiterbahn stellen die Strom- bzw. Energieversorgung des Feuchtesensors zur Durchführung der Feuchtemessung sicher.

Zur Funktionsüberprüfung der elektrischen Kontaktierung des Feuchtesensors ist erfindungsgemäß eine Teststruktur vorgesehen, die mit der Zuleitung und der Kontakt-Leiterbahn elektrisch verbunden ist.

Die Teststruktur ermöglicht es, insbesondere die korrekte elektrische Kontaktierung bzw. Verbindung sowohl der Verbindung zwischen Feuchtesensor und Zuleitung als auch der Verbindung zwischen Feuchtesensor und Kontakt-Leiterbahn zu überprüfen.

Zudem ermöglicht es die Teststruktur zu überprüfen, ob die Kontakt-Leiterbahn und/oder die Zuleitung elektrisch korrekt angeschlossen sind, insbesondere mit Strom versorgbar sind. Insbesondere ermöglicht es die Teststruktur zu überprüfen, ob der Feuchtesensor korrekt angeschlossen und im angeschlossenen Zustand mit Strom bzw. Energie versorgt wird.

Bevorzugt schließt die Teststruktur die Kontakt-Leiterbahn und die Zuleitung elektrisch kurz. Jedoch kann der Widerstand der Teststruktur so gewählt werden, dass dies die Funktionsfähigkeit bei der Feuchtemessung im regulären Zustand nicht beeinträchtigt und insbesondere nur bei der Funktionsüberprüfung genutzt wird.

Erfindungsgemäß gelingt es insbesondere, einen gedruckten und auf seine Funktionalität bzw. Kontaktierung überprüfbaren bzw. testbaren Feuchtesensor bereitzustellen. So wird insbesondere ermöglicht, die Herstellungskosten für eine erfindungsgemäße Baubahn im Vergleich zum Stand der Technik drastisch zu reduzieren, da der Feuchtesensor letztlich während der Herstellung der Baubahn, vorzugsweise im Inline-Verfahren, hergestellt und eine aufwendige Kontrolle der korrekten Herstellung durch eine Überprüfbarkeit der Funktionalität des Feuchtesensors bzw. der Baubahn vereinfacht werden kann.

Insbesondere kann der Feuchtesensor gemeinsam mit den weiteren Bestandteilen der Elektronikeinheit, bevorzugt der Zuleitung und/oder der Kontakt-Leiterbahn, und/oder der Teststruktur auf die Trägerschicht aufgebracht, bevorzugt aufgedruckt, werden.

Vorteilhafterweise kann mit der erfindungsgemäßen Baubahn unter wirtschaftlichen Gesichtspunkten, insbesondere im Flachdachbereich, eine Überwachung der Feuchtigkeit im Dachaufbau sichergestellt werden. So kann rechtzeitig das unerwünschte Eindringen von Feuchtigkeit im Dachaufbau erkannt werden, so dass insbesondere langfristige Schäden aufgrund eines Wasserschadens verhindert werden können.

Auch kann vermieden werden, dass eine nicht korrekt funktionierende Baubahn eingesetzt wird, die im Schadenfall bzw. bei eintretender Feuchtigkeit die Feuchtigkeit nicht detektieren kann. Die Sicherheit wird folglich durch die erfindungsgemäße Baubahn erhöht.

Dadurch, dass der erfindungsgemäße Feuchtesensor insbesondere gedruckt wird, kann eine Mehrzahl von Feuchtesensoren über die Länge der Baubahn mit geringen Herstellungskosten bereitgestellt werden. Dies ermöglicht eine vergleichsweise genaue Detektion eines Lecks, da die Stelle des Eindringens von Wasser über die Bestimmung des die Feuchtigkeit detektierenden Feuchtesensors bestimmbar ist.

Bei einer Mehrzahl von Feuchtesensoren zeigt sich weiter auch der Vorteil der Teststruktur, dass eine Funktionsüberprüfung der einzelnen Feuchtesensoren bevorzugt unabhängig voneinander gewährleistet werden kann. Hierzu können vorzugsweise mehrere Teststrukturen eingesetzt werden, was nachfolgend im Einzelnen noch ausgeführt wird.

Des Weiteren ist bei der vorliegenden Erfindung besonders vorteilhaft, dass nichtfunktionsfähige und bereits montierte Baubahnen nicht mehr zugänglich sind und in der Regel der gesamte Dachaufbau geöffnet werden muss, um die Baubahn auszutauschen. Und selbst ein solcher Austausch wird erst veranlasst, wenn bereits ein Feuchteschaden, der nicht detektiert werden konnte, eingetreten ist. Die Erfindung schafft nun die Möglichkeit auf vergleichsweise einfache Weise zum Beispiel am Montageort eine Funktionsüberprüfung durchzuführen, die insbesondere auch vor Montage oder kurz nach erfolgter Montage erfolgen kann. Selbst im montierten Zustand, in dem die Baubahnen nicht mehr zugänglich sind, kann durch die erfindungsgemäße Teststruktur eine Funktionsüberprüfung des Feuchtesensors erfolgen, so dass insbesondere ein korrekter elektrischer Anschluss der Baubahn sichergestellt werden kann.

Neben der Prüfung der korrekten Installation, insbesondere des korrekten Anschlusses der Baubahn an eine Energie- und/oder Stromversorgung, der Baubahn kann erfindungsgemäß über die Teststruktur auch die korrekte Funktionsweise bzw. der korrekte Betrieb der Baubahn, insbesondere des Feuchtesensors, erkannt und bevorzugt überprüft werden.

Des Weiteren weist die erfindungsgemäße Elektronikeinheit eine hohe mechanische Stabilität auf, insbesondere wobei die Elektronikeinheit auch aufrollbar und/oder knickbar ausgebildet ist, was insbesondere eine einfache Verlegung der Baubahn ermöglicht.

Bei einer besonders bevorzugten Ausführungsform ist die Teststruktur parallel zum Feuchtesensor geschaltet. Dies ermöglicht es, dass die Teststruktur sowohl mit der Zuleitung als auch mit der Kontakt-Leiterbahn verbunden werden kann, da sowohl die Zuleitung als auch die Kontakt-Leiterbahn mit dem Feuchtesensor verbunden ist. Die Teststruktur kann nun feststellen, ob sowohl die Zuleitung als auch die Kontakt-Leiterbahn eine entsprechende elektrische Stromleitung ermöglichen kann - demnach kann festgestellt werden, ob die Zuleitung und die Kontakt-Leiterbahn korrekt elektrisch angeschlossen und bevorzugt mit Strom bzw. Energie versorgbar sind. Sofern der Feuchtesensor noch keine Feuchtigkeit detektiert, kann über diesen auch keine Funktionsüberprüfung ohne einen Feuchteeintritt durchgeführt werden. Die Teststruktur ergibt nun den Vorteil, dass eine vermeintliche Detektion eines Feuchtefalls letztlich simuliert werden kann, was entsprechend ausgelesen bzw. überprüft werden kann. Die Teststruktur ist dabei vorzugsweise jedoch so dimensioniert und/oder ausgebildet, dass bei entsprechender Auswertung der Messergebnisse zwischen Messsignalen des Feuchtesensors und durch die Teststruktur hervorgerufenen Messsignalen unterschieden werden kann.

Vorzugsweise ist die Teststruktur als Testleiterbahnabschnitt ausgebildet. Der Testleiterbahnabschnitt kann dann separat oder gemeinsam mit der Kontakt-Leiterbahn und/oder der Zuleitung auf die Trägerschicht aufgebracht werden. Bevorzugt ist die Teststruktur auch Teil der Elektronikeinheit der Baubahn. Die Ausbildung der Teststruktur als Testleiterbahnabschnitt ermöglicht eine an die jeweilige Benutzungssituation angepasste Ausbildung der Teststruktur und stellt ferner sicher, dass eine exakte Anordnung der Teststruktur auf der Trägerschicht möglich ist. Dies gelingt insbesondere, wenn die Teststruktur bzw. der Testleiterbahnabschnitt aufgedruckt wird. Ein Aufdrucken kann gewährleisten, dass die Zuleitung und die Kontakt-Leiterbahn elektrisch kontaktiert wird.

Bei einer weiteren bevorzugten Ausführungsform der vorliegenden Erfindung ist vorgesehen, dass die Teststruktur einen elektrischen Widerstand zwischen 0,1 bis 30 MΩ, bevorzugt zwischen 1 bis 10 MΩ, aufweist. Ein solcher Widerstand ermöglicht es, dass trotz Kurzschließen der Zuleitung mit der Kontakt-Leiterbahn bei Feuchtedetektion durch den Feuchtesensor die Teststruktur das Messergebnis der Feuchtemessung zumindest im Wesentlichen nicht stark beeinflusst und/oder beeinträchtigt.

Bei einer weiteren bevorzugten Ausgestaltung ist vorgesehen, dass die Länge des Testleiterbahnabschnittes größer als der Abstand zwischen der Zuleitung und der Kontaktleiterbahn ist. Unter dem Abstand zwischen der Zuleitung und der Kontakt-leiterbahn wird insbesondere der kürzeste Abstand verstanden. Die Länge des Testleiterbahnabschnittes ergibt sich durch die gesamte Weglänge des Testleiterbahnabschnittes. Ist dieser beispielsweise gewunden ausgebildet, so ist unter der Länge des Testleiterbahnabschnittes letztlich die Länge im ausgezogenen Zustand zu verstehen. Die erhöhte Länge ergibt den Vorteil, dass bei Ausbildung der Teststruktur als Testleiterbahnabschnitt der Widerstand der Teststruktur erhöht werden kann, was sich auch durch eine nicht gerade Struktur der Teststruktur ergibt.

Bevorzugt ist die Teststruktur keine geradförmige Linie, wodurch sich insbesondere die Länge des Testleiterbahnabschnittes erhöht und diese Länge dann auch den Abstand zwischen der Zuleitung und der Kontakt-Leiterbahn übersteigt, insbesondere um ein Mehrfaches.

Vorzugsweise weist die Teststruktur eine Mehrzahl von Windungen bzw. Schlaufen auf. Insbesondere ist die Teststruktur mäanderförmig ausgebildet bzw. verläuft zwischen der Zuleitung und der Kontakt-Leiterbahn mäanderförmig. Die vorgenannte Ausbildung ermöglicht es insbesondere, die Länge des Testleiterbahnabschnittes bei Ausbildung der Struktur als Testleiterbahnabschnitt zu erhöhen, wodurch auch die Länge des Testleiterbahnabschnittes den Abstand zwischen Zuleitung und Kontakt-Leiterbahn zum Teil deutlich übersteigen kann. Eine solche Ausbildung der Teststruktur kann ferner bei Produktion bzw. Herstellung der Teststruktur unmittelbar aufgebracht werden. Insbesondere wird die Teststruktur gedruckt, wobei sich die Windungen des Testleiterbahnabschnittes vergleichsweise einfach im Druckbild realisieren lassen. Der Widerstand der Teststruktur kann somit auf einfache Weise, die mit geringen Herstellungskosten verbunden ist, erhöht werden.

Vorzugsweise ist der Feuchtesensor als resistive und/oder kapazitiver Feuchtesensor ausgebildet. Insbesondere wird der resistive und/oder kapazitive Feuchtesensor durch wenigstens zwei insbesondere benachbarte elektrisch leitfähige Messleiterbahnen zur resistiven und/oder kapazitiven Feuchtemessung gebildet. Zwischen den wenigstens zwei elektrisch leitfähigen Messleiterbahnen kann wenigstens eine Wasserleitung vorgesehen sein. Bei der Wasserleitung handelt es sich um einen Bereich, in dem während des verlegten Zustands der Baubahn Wasser oder Feuchtigkeit auftreten kann. Wenn Wasser bzw. Feuchtigkeit in der Wasserleitung zwischen den elektrisch leitfähigen Messleiterbahnen vorhanden ist, gelingt es, den elektrischen Widerstand bzw. die Kapazität derart zu beeinflussen, dass über den Feuchtesensor eine Detektion von Feuchtigkeit erfolgen kann. In diesem Zusammenhang kann erfindungsgemäß das physikalische Prinzip ausgenutzt werden, dass sich der elektrische Widerstand bzw. die Kapazität beim Eindringen von Wasser und/oder Feuchtigkeit in einer Wasserleitung - die zwischen zwei unmittelbar benachbarten Messleiterbahnen gebildet wird - verändert. Somit wird die Veränderung des ohmschen Widerstandes und/oder der elektrischen Kapazität zum Detektieren der Feuchtigkeit verwendet.

Bevorzugt ist die erste Messleiterbahn elektrisch mit der Zuleitung und die zweite Messleiterbahn elektrisch mit der Kontakt-Leiterbahn verbunden. Folglich können die Messleiterbahnen des Feuchtesensors durch die Zuleitung und die Kontakt-Leiterbahn mit Strom zur Feuchtemessung versorgt werden. Eine Stromversorgung des Feuchtemessers ist bei der Feuchtemessung deswegen sinnvoll, da die Feuchtemessung anhand eines Unterschiedes des ermittelten Widerstands zwischen den Messleiterbahnen erfassbar ist, wie dies zuvor ausgeführt worden ist. Zum Erfassen des Wiederstandes müssen jedoch die Zuleitung und die Kontakt-Leiterbahnen mit Strom versorgt werden. Diese Stromversorgung kann dann an die Messleiterbahnen übergeben werden.

Darüber hinaus ist bei einer weiteren bevorzugten Ausgestaltung des Erfindungsgedankens vorgesehen, dass die wenigstens zwei Messleiterbahnen des Feuchtesensors an ihren einander zugewandten Enden zur Bildung eines Sensorbereichs zumindest bereichsweise miteinander kämmen. Alternativ oder zusätzlich kann vorgesehen sein, dass die wenigstens zwei Messleiterbahnen des Feuchtesensors jeweils eine Mehrzahl von abstehenden Fingern aufweisen, wobei, vorzugsweise, die Finger der Messleiterbahnen ineinandergreifen und/oder miteinander kämmen können. Insbesondere kann zwischen zwei unmittelbar benachbarten Fingern der Messleiterbahnen die wenigstens eine Wasserleitung zur resistiven Feuchtemessung ausgebildet werden. So kann insbesondere ein zumindest im Wesentlichen labyrinthartige Struktur des Feuchtesensors erhalten werden.

Insbesondere ist der Feuchtesensor als ein gerundetes, insbesondere zumindest im Wesentlichen kreisförmiges, Sensorfeld ausgebildet. Aber auch andere Formen des Sensorfeldes sind möglich. Jedenfalls sollte gewährleistet sein, dass die wenigstens zwei Messleiterbahnen miteinander kämmend in einem Sensorfeld angeordnet sind.

Bei einer weiteren bevorzugten Ausführungsform ist vorgesehen, dass eine Mehrzahl von Feuchtesensoren vorhanden ist. Die zweite Messleiterbahn des jeweiligen Feuchtesensors kann mit einer eine Mehrzahl von Leiterbahnen aufweisenden Leitungseinrichtung elektrisch verbunden sein. Der Feuchtesensor kann demnach mit der Zuleitung und der Leitungseinrichtung verbunden sein. Die Leitungseinrichtung kann demnach die Kontakt-Leiterbahn umfassen. Die Leitungseinrichtung kann gewährleisten, dass jedem Sensor bei einer Mehrzahl von Feuchtesensoren die benötigte elektrische Energie bzw. der zur Feuchtemessung benötigte Strom zugeführt werden kann.

Insbesondere sind alle ersten Messleiterbahnen der mehreren Feuchtesensoren mit ein und derselben elektrischen Zuleitung verbunden. Die Kontakt-Leiterbahnen für die zweiten Messleiterbahnen der Feuchtesensoren können jedoch unabhängig voneinander bereitgestellt werden.

Bei der Bereitstellung von mehreren Feuchtesensoren ist besonders bevorzugt eine gruppierte Anordnung der Sensoren zu realisieren. Die gruppierte Anordnung ergibt den Vorteil, dass eine gruppenweise Verarbeitung der Sensorsignale der Feuchtesensoren erfolgen kann und insbesondere auch einer Sensorgruppe als solches elektrische Energie zur Verfügung gestellt werden kann, insbesondere ohne dass jedem Feuchtesensor einzeln bzw. der benötigte Strom bzw. die benötigte Energie zugeführt werden muss. Durch die gruppierte Anordnung der Feuchtesensoren kann ferner der Vorteil geschaffen werden, dass festgestellt werden kann, in welchem Bereich welcher Sensorgruppe ein Feuchteeintritt detektiert worden ist.

Grundsätzlich versteht es sich aber auch, dass eine individuelle Lokalisation der Feuchtesensoren erfolgen kann, insbesondere wenn die Sensorgruppe nur einen Feuchtesensor oder unter 5 Feuchtesensoren aufweist, der entsprechend mit Strom versorgt wird. Es kann auch vorgesehen sein, dass wenigstens eine Sensorgruppe nur einen Feuchtesensor und weitere Sensorgruppen mehr als einen Feuchtesensor aufweisen können. Ist beispielsweise in einem Bereich eine erhöhte Gefahr eines Feuchteeintritts vorhanden, kann dort ein Sensorbereich weniger Feuchtesensoren als in einem anderen Bereich mit einer geringeren Gefahr des Feuchteeintritts aufweisen. Eine höhere Gefahr des Feuchteeintritts kann beispielsweise im Bereich eines Durchbruchselements, wie ein Luftrohr, Lichtschacht oder dergleichen, vorhanden sein.

Vorzugsweise ist eine Mehrzahl von jeweils wenigstens einem Feuchtesensor gebildete Sensorgruppen vorgesehen. Jede Sensorgruppe kann eine mit der zweiten Messleiterbahn des jeweiligen Feuchtesensors der jeweiligen Sensorgruppe elektrisch verbundene Leitungseinheit der Leitungseinrichtung zugeordnet sein. Demnach kann die Leitungseinrichtung Leitungseinheiten für die unterschiedlichen Sensorgruppen umfassen. Dabei wird insbesondere je Sensorgruppe eine Leitungseinheit bereitgestellt. Die einzelnen Leitungseinheiten können elektrisch voneinander über wenigstens eine Trennstelle und/oder Trennstellen getrennt sein. Die Trennstellen können den jeweiligen Leiterbahnen und/oder in den jeweiligen zweiten Messleiterbahnen vorhanden sein. Die Leitungseinheiten sind insbesondere durch Abschnitte der Leiterbahnen gebildet, wie im Folgenden noch erläutert wird. Die Bereitstellung der Trennstellen ermöglicht es auf vergleichsweise einfache Art und Weise die Leitungseinheiten voneinander elektrisch zu trennen und jeder Sensorgruppe unabhängig voneinander elektrisch Energie zuzuführen. Diese unabhängige bzw. voneinander isolierte Bereitstellung der Leitungseinheiten wiederum eröffnet die Möglichkeit, dass bei festgestelltem Feuchteeintritt genau diejenige Leitungseinheit ermittelt werden kann, die diesen Feuchteeintritt feststellt. Da über die jeweilige Leitungseinheit auch Kenntnis der jeweiligen Sensorgruppe, in denen sich der die Feuchtigkeit detektierende Feuchtesensor befindet, gegeben ist, kann dies wiederum zur Ermittlung der Position oder des Bereichs des Feuchtesensors führen, der den Feuchteeintritt festgestellt hat.

Die Trennstellen können bereits bei der Herstellung der Baubahn eingebracht werden, insbesondere nach dem Aufdrucken der Elektronikeinheit, insbesondere durch entsprechende Materialwegnahme der Leiterbahnen.

Bei einer besonders bevorzugten Ausgestaltung der Erfindung ist vorgesehen, dass die Anzahl der Teststrukturen wenigstens der Anzahl der Sensorgruppen entspricht und/oder diese übersteigt. Insbesondere kann jedem Feuchtesensor eine eigene Teststruktur zugeordnet sein. Demnach wird ermöglicht, dass für jeden Feuchtesensor und/oder für jede Sensorgruppe eine Funktionsüberprüfung durch die jeweilige zugeordnete Teststruktur erfolgen kann.

Es versteht sich, dass erfindungsgemäß auch eine einzelne Teststruktur besonders vorteilhaft ist, da so die elektrische Kontaktierung der Baubahn überprüfbar ist.

Wird jedoch eine Teststruktur für jeden Sensorbereich und/oder jeden Feuchtesensor bereitgestellt, so ergibt sich der weitere Vorteil, dass auch für jeden Feuchtesensor oder jede Sensorgruppe die elektrische Kontaktierung sichergestellt und überprüft werden kann. Die elektrische Kontaktierung der Sensorgruppen kann über die Leitungseinheiten gewährleistet werden. Demnach entspricht insbesondere die Anzahl der Teststrukturen wenigstens der Anzahl der Leitungseinheiten. So können die Teststrukturen den korrekten elektrischen Anschluss der Leitungseinheiten überprüfen. Die Leitungseinheiten können mit einer externen Stromversorgung verbunden sein, dessen Anschluss wiederum über die Teststruktur überprüfbar ist.

Die Kontakt-Leiterbahn des jeweiligen Feuchtesensors kann durch die Leitungseinheit der jeweiligen Sensorgruppe des Feuchtesensors gebildet sein bzw. die jeweilige Leitungseinheit kann die entsprechende Kontakt-Leiterbahn umfassen. Die Kontakt-Leiterbahn kann als Bestandteil der Leitungseinheit der jeweiligen Sensorgruppe ausgebildet sein. Demnach können auch die Kontakt-Leiterbahnen bei einer Mehrzahl von Feuchtesensoren eingesetzt werden. Die Kontakt-Leiterbahnen stelten somit auch bei Zuordnung zu der Leitungseinheit die elektrische Energieversorgung des Feuchtesensors sicher.

Besonders bevorzugt ist, wenn eine Leiterbahn einen mit einer elektrischen Verbindungseinrichtung der Baubahn verbindbaren Hauptleiterbahnabschnitt und wenigstens einen von dem Hauptleiterbahnabschnitt dieser Leiterbahn elektrisch getrennten Nebenleiterbahnabschnitt aufweist.

Die Nebenleiterbahnabschnitte können von dem Hauptleiterbahnabschnitt durch Trennstellen elektrisch getrennt sein. Auch bei mehreren Nebenleiterbahnabschnitten einer Leiterbahn kann eine Trennung bzw. eine elektrische Isolierung der Nebenleiterbahnabschnitte derselben Leiterbahn voneinander über die Trennstellen erfolgen.

Die Unterbrechung einer Leiterbahn in mehrere Leiterbahnabschnitte ergibt den Vorteil, dass bei der Bereitstellung von insbesondere parallel zueinander verlaufenden Leiterbahnen eine individuelle Stromzuführung zu den einzelnen Sensorgruppen und/oder den einzelnen Feuchtesensor erfolgen kann.

Würde beispielsweise jede Leiterbahn mit jedem Feuchtesensor verbunden und würden mehrere Feuchtesensoren vorgesehen sein, so würde sich die Problematik ergeben, dass bei Detektion von Feuchtigkeit nur schwer eine Position bestimmbar ist.

Die Bereitstellung von Trennstellen ermöglicht es ferner, dass nach dem Aufdrucken der Elektronikeinheit im Inline-Verfahren vergleichsweise einfach unterschiedliche Sensorgruppen gebildet werden können. Würde beispielsweise jeweils genau eine Leiterbahn zu einem Feuchtesensor oder einer Sensorgruppe führen, so wäre dies mit hohem produktionstechnischem Aufwand verbunden, da insbesondere kein wiederholbares Druckbild genutzt werden kann. Erfindungsgemäß gelingt es jedoch, über die Nutzung von Trennstellen ein sich stets wiederholendes Druckbild zu nutzen, das durch das Einbringen von Trennstellen so verändert werden kann, dass jedem Feuchtesensor letztlich eine separate bzw. jeder Sensorgruppe eine separate Energieversorgung zugestanden werden kann.

Produktionstechnisch ist es so, dass die Elektronikeinheit beispielsweise im Rapportdruckverfahren oder mit anderen Druckverfahren hergestellt werden kann und sich insbesondere in regelmäßigen Abständen im Design wiederholt. Somit kann produktionsseitig nur vergleichsweise schwer eine separate Stromzuführung zu den einzelnen Feuchtesensoren umgesetzt werden. Erfindungsgemäß wird diese Problematik jedoch durch die Bereitstellung von Hauptleiterbahnabschnitten und Nebenleiterbahnabschnitten unter der Verwendung von Trennstellen gelöst.

Besonders bevorzugt ist die Teststruktur unmittelbar mit der Zuleitung und der zu der Zuleitung am nächsten angeordneten Leiterbahn, insbesondere dem am nächsten liegenden Leiterbahnabschnitt elektrisch verbunden. Der nächstliegende Leiterbahnabschnitt kann entweder ein Hauptleiterbahnabschnitt oder ein Nebenleiterbahnabschnitt sein. Somit kann auch die Teststruktur in dem sich in regelmäßigen Abständen wiederholenden Druckbild bereitgestellt werden.

Eine elektrische Kontaktierung des Feuchtesensors sowie der Teststruktur zwischen der Hauptleiterbahn und dem dem jeweiligen Feuchtesensor zugeordneten Nebenleiterbahnabschnitt kann dabei auch dann erfolgen, wenn die Teststruktur mit einem Nebenleiterbahnabschnitt verbunden ist, insbesondere sofern der Nebenleiterbahnabschnitt dann wiederum mit dem dem Feuchtesensor zugeordneten Hauptleiterbahnabschnitt elektrisch verbunden ist. Eine solche Ausbildung kann über die Bereitstellung von Trennstellen gewährleistet werden.

Letztlich könnte natürlich auch erfindungsgemäß die Teststruktur so angeordnet sein, dass sie die elektrische Zuleitung für jeden Feuchtesensor bzw. bei jeder Teststruktur unmittelbar mit dem jeweiligen Hauptleiterbahnabschnitt des Feuchtesensors elektrisch verbindet, insbesondere ohne Zwischenschaltung von Nebenleiterbahnabschnitten.

Die alternative Ausführungsform jedoch, nämlich die elektrische Verbindung der Zuleitung mit dem am nächsten liegenden Leiterbahnabschnitt über die Teststruktur ergibt den Vorteil, dass die Teststruktur bei einem wiederkehrenden Muster der Elektronikeinheit stets an der gleichen Stelle, insbesondere neben dem Feuchtesensor, angeordnet werden und stets eine Funktionsüberprüfung für den jeweiligen Feuchtesensor realisieren kann. Dies vereinfacht die produktionstechnische Bereitstellung der Teststrukturen, reduziert aber gleichzeitig auch die Fehleranfälligkeit bei Ausbildung der Teststrukturen und der elektrischen Kontaktierung zwischen Teststruktur und dem jeweiligen Hauptleiterbahnabschnitt. Sofern die Teststruktur mit einem Nebenleiterbahnabschnitt unmittelbar elektrisch verbunden ist, so kann die Teststruktur mittelbar über die elektrische Verbindung dieses Nebenleiterbahnabschnittes zu dem dem jeweils zu überprüfenden Feuchtesensor zugeordneten Hauptleiterbahnabschnitt erfolgen.

Besonders bevorzugt ist wenigstens eine Leitungseinheit, insbesondere allen Leitungseinheiten, ein Hauptleiterbahnabschnitt einer Leiterbahn und wenigstens ein, bevorzugt eine Mehrzahl von, Nebenleiterbahnabschnitt(en) wenigstens einer anderen Leiterbahn zugeordnet. Insbesondere ist der jeweiligen Leitungseinheit ein Hauptleiterbahnabschnitt der der Leitungseinheit zugeordneten Leiterbahn und Nebenleiterbahnabschnitte aller anderen Leiterbahnen zugeordnet.

Darüber hinaus ist vorteilhafterweise vorgesehen, dass wenigstens eine zweite Messleiterbahn eines Feuchtesensors einer jeweiligen Sensorgruppe elektrisch mit dem Hauptleiterbahnabschnitt der zugeordneten Leitungseinheit verbunden ist und wenigstens einen Nebenleiterbahnabschnitt der zugeordneten Leitungseinheit kreuzt und elektrisch verbunden ist, wobei die zweite Messleiterbahn von dem wenigstens einen Hauptleiterbahnabschnitt einer anderen Leitungseinheit durch wenigstens eine Trennstelle, bevorzugt in der zweiten Messleiterbahn, elektrisch getrennt ist. Die zweite Messleiterbahn kann folglich insbesondere die Nebenleiterbahnabschnitte der jeweiligen Leitungseinheit zu dem Hauptleiterbahnabschnitt elektrisch verbinden. Besonders bevorzugt ist der die Leiterbahnen kreuzende Abschnitt der zweiten Messleiterbahn zumindest im Wesentlichen orthogonal zu den Leiterbahnen angeordnet, die besonders bevorzugt zueinander parallel verlaufen, insbesondere in Längsrichtung der Baubahn. Demnach kann der die Leiterbahn kreuzende Abschnitt der Messleiterbahn besonders bevorzugt zumindest im Wesentlichen orthogonal zur Längsrichtung der Baubahn verlaufen. Allerdings sind in weiteren Ausführungsformen auch andere Ausrichtungen sowohl der Leiterbahn als auch der zweiten Messleiterbahn möglich.

Besonders bevorzugt kreuzt ein Nebenleiterbahnabschnitt einer Leitungseinheit alle zweiten Messleiterbahnen der der Leitungseinheit zugeordneten Sensorgruppe und ist elektrisch mit diesen verbunden. Demnach ist es nicht nötig, die Nebenleiterbahnabschnitte der jeweiligen Leiterbahn voneinander zu trennen, sondern einen Nebenleiterbahnabschnitt je Sensorgruppe je Leiterbahn bereitzustellen.

Des Weiteren ist bei einer weiteren bevorzugten Ausführungsform vorgesehen, dass die Zuleitung, die Teststruktur, die Leitungseinheit und/oder die Leiterbahn der Leitungseinrichtung und/oder die Elektronikeinheit auf die Außenseite der Trägerschicht aufgebracht, insbesondere aufgedruckt, sind. Die Trennstellen können insbesondere nach Aufdrucken der Elektronikeinheit und/oder der vorgenannten Leiterbahnen eingebracht werden. Besonders bevorzugt wird die Teststruktur gemeinsam mit den weiteren Komponenten der Elektronikeinheit aufgebracht. Insbesondere kann die Teststruktur auch vor Einbringen der Trennstellen aufgebracht, insbesondere aufgedruckt werden, wodurch die Trennstellen die jeweilige elektrische Kontaktierung zwischen der Teststruktur und dem jeweiligen Hauptleiterbahnabschnitt gewährleistet werden kann.

Darüber hinaus ist bei einer weiteren bevorzugten Ausführungsform vorgesehen, dass die Trägerschicht wasserdicht ausgebildet ist.

Insbesondere ist die Trägerschicht als, vorzugsweise wasserdichte, Folienschicht ausgebildet. Die Trägerschicht kann als Material einen Kunststoff, vorzugsweise einen thermoplastischen Kunststoff, weiter bevorzugt Polypropylen, Polyethylen und/oder Polyethylenterephthalat (PET), aufweisen und/oder daraus bestehen. Insbesondere ist die Trägerschicht als PET-Folie ausgebildet.

Ferner kann die Trägerschicht alternativ oder zusätzlich diffusionsoffen, insbesondere wasserdampfdurchlässig, und/oder wasserdicht und/oder atmungsaktiv ausgebildet sein. Alternativ oder zusätzlich kann vorgesehen sein, dass die Trägerschicht diffusionsdicht, diffusionshemmend, wasserdampfundurchlässig und/oder wasserdicht ausgebildet ist. Die Ausbildung der Trägerschicht kann insbesondere in Abhängigkeit des Einsatzortes und/oder der Ausbildung der Baubahn erfolgen. Beispielsweise kann die Baubahn an Bahnen einer Gebäudehülle angeordnet werden. In Abhängigkeit der diesbezüglichen Anordnung kann die Trägerschicht entweder diffusionsoffen oder diffusionsdurchlässig ausgebildet sein. Insbesondere ist die Trägerschicht so ausgebildet, dass der Feuchtesensor über den Feuchtetransport längs der Textilschicht das Eindringen von ungewünschter Feuchtigkeit detektieren kann.

Bei einer weiteren bevorzugten Ausführungsform ist ein wenigstens die Trägerschicht und eine wasserdurchlässige, vorzugsweise wasseraufnehmende, Textilschicht aufweisender mehrlagiger Schichtaufbau vorgesehen. Demnach kann insbesondere die Elektronikeinheit der Trägerschicht zugeordnet werden. Die Textilschicht kann insbesondere dazu vorgesehen sein, die Feuchtigkeit zu den Feuchtesensoren zu transportieren. So kann die Textilschicht auch sicherstellen, dass mit einer hohen Genauigkeit ein Feuchteschaden detektiert werden kann, da insbesondere auch Feuchtigkeit, die nicht unmittelbar am Feuchtesensor anliegt, über die Textilschicht und durch entsprechendes Ausbreiten der Feuchtigkeit in der Textilschicht wenigstens einem Feuchtesensor zugeführt werden kann.

Besonders bevorzugt ist dabei die Textilschicht in Kontakt zu der Elektronikeinheit und/oder den Feuchtesensoren. Ferner kann die Textilschicht unmittelbar oder mittelbar an der Elektronikeinheit bzw. den Feuchtesensoren anliegen, insbesondere aber derart, dass in der Textilschicht vorhandene Feuchtigkeit über den Feuchtesensor detektierbar ist. Alternativ oder zusätzlich kann vorgesehen sein, dass die Elektronikeinheit zwischen der Trägerschicht und der Textilschicht vorgesehen ist, wobei zwischen der Textilschicht und der Elektronikeinheit eine Klebeschicht zur stoffschlüssigen Verbindung der Textilschicht mit der Elektronikeinheit vorgesehen ist.

Bei einer weiteren bevorzugten Ausführungsform ist vorgesehen, dass der, insbesondere minimale, Abstand unmittelbar benachbarter Finger des Sensorfeldes und/oder die, insbesondere maximale, Breite wenigstens einer zwischen den wenigstens zwei Messleiterbahnen gebildeten Wasserleitung weniger als 1 cm, bevorzugt weniger als 0,5 cm, weiter bevorzugt weniger als 0,3 cm, vorzugsweise zwischen 1 mm bis 10 mm, beträgt. Letztlich kann auch die Breite zwischen den unmittelbar benachbarten Fingern der Messleiterbahnen variieren. Insbesondere ist der Abstand derart gewählt, dass die resistive Feuchtemessung bei Eindringen von Feuchtigkeit und/oder Wasser in die Wasserleitung durch die Veränderung des ohmschen Widerstandes von dem Feuchtesensor detektiert werden kann.

Ferner können unmittelbar benachbarte Feuchtesensoren einer Sensorgruppe einen Abstand zwischen 10 cm bis 5 m, bevorzugt zwischen 20 cm bis 3 m, weiter bevorzugt zwischen 40 cm bis 1,5 m, aufweisen. Alternativ oder zusätzlich kann vorgesehen sein, dass der Abstand unmittelbar benachbarter Feuchtesensoren wenigstens 5 cm, bevorzugt wenigstens 10 cm, weiter bevorzugt wenigstens 20 cm und/oder kleiner als 5 m, bevorzugt kleiner als 3 m, weiter bevorzugt kleiner als 1,5 m, ausgebildet ist. Der Abstand der Feuchtesensoren kann insbesondere von der gewünschten Genauigkeit der Lokalisation eines möglichen Lecks in dem Dachaufbau abhängig sein. Je engmaschiger die Feuchtesensoren angeordnet sind, desto genauer kann ein Leck erkannt werden. Erfindungsgemäß gelingt es jedoch auch bei einem größeren Abstand unmittelbar benachbarter Feuchtesensoren zumindest im Wesentlichen sicher, das Eindringen von Feuchtigkeit im Bereich der Baubahn zu detektieren, indem der Feuchtetransport innerhalb der Textilschicht genutzt werden kann.

Die Feuchtesensoren können besonders bevorzugt zueinander gleich beabstandet sein. Alternativ oder zusätzlich kann vorgesehen sein, dass zumindest die Feuchtesensoren einer Sensorgruppe innerhalb dieser Sensorgruppe zumindest im Wesentlichen gleich beabstandet sind.

Darüber hinaus ist bei einer weiteren bevorzugten Ausführungsform vorgesehen, dass die Trägerschicht eine Breite zwischen 1 bis 100 cm, bevorzugt zwischen 10 bis 50 cm, weiter bevorzugt zwischen 13 bis 20 cm, aufweist. Alternativ oder zusätzlich kann vorgesehen sein, dass die Textilschicht eine Breite zwischen 0,1 bis 3 m, bevorzugt zwischen 0,1 bis 0,3 m, aufweist. Vorzugsweise haben die Trägerschicht und die Textilschicht die gleiche Länge und/oder verlaufen beide in Längsrichtung und/oder sind langgestreckt ausgebildet. Die Länge der Baubahn und/oder der Trägerschicht und/oder der Textilschicht kann zwischen 0,5 m bis 50 m, bevorzugt zwischen 3 m bis 20 m, betragen.

Ferner ist bei einer weiteren bevorzugten Ausführungsform vorgesehen, dass die Hauptleiterbahnabschnitte und/oder die Zuleitung zu der externen Anschlusseinrichtung elektrisch über jeweils wenigstens ein Verbindungsmittel der Verbindungseinrichtung verbindbar sind. Das Verbindungsmittel kann zu einem weiteren Verbindungsmittel der Anschlusseinrichtung komplementär ausgebildet und mit dem weiteren Verbindungsmittel formschlüssig und/oder reibschlüssig und/oder verrastbar verbindbar sein. Die vorgenannte Verbindung stellt eine vergleichsweise einfache Möglichkeit dar, die Baubahn und die Elektronikeinheit der Baubahn mit Energie bzw. Strom zu versorgen. Dabei muss kein Energiespeicher der Baubahn zugeordnet sein, sondern die externe elektrische Kontaktierung der Baubahn kann über Verbindung zwischen der Verbindungseinrichtung und der Anschlusseinrichtung erfolgen. Hierzu können dann die ersten und weiteren Verbindungsmittel entsprechend miteinander elektrisch verbunden werden und somit eine Energiezuführung zu den einzelnen Feuchtesensoren der Elektronikeinheit sicherstellen. Insbesondere kann die vorgenannte Verbindung werkzeuglos erfolgen und eine dauerhafte elektrische Kontaktierung gewährleisten.

Im Übrigen versteht es sich, dass in den vorgenannten Intervallen und Bereichsgrenzen jegliche Zwischenintervalle und Einzelwerte enthalten und als erfindungswesentlich offenbart anzusehen sind, auch wenn diese Zwischenintervalle und Einzelwerte nicht konkret angegeben sind.

Weitere Merkmale, Vorteile und Anwendungsmöglichkeiten der vorliegenden Erfindung ergeben sich aus der nachfolgenden Beschreibung von Ausführungsbeispielen anhand der Zeichnung und der Zeichnung selbst. Dabei bilden alle beschriebenen und/oder bildlich dargestellten Merkmale für sich oder in beliebiger Kombination den Gegenstand der vorliegenden Erfindung, unabhängig von ihrer Zusammenfassung in den Ansprüchen oder deren Rückbeziehung.

Es zeigt:
- Fig. 1: eine schematische Darstellung einer Baubahn,
- Fig. 2: eine schematische Detailansicht aus Fig. 1,
- Fig. 3A: eine schematische Darstellung einer weiteren Ausführungsform einer Baubahn mit hervorgehobener erster Sensorgruppe,
- Fig. 3B: eine schematische Darstellung der in Fig. 3A gezeigten Baubahn mit hervorgehobener zweiter Sensorgruppe,
- Fig. 3C: eine schematische Darstellung der in Fig. 3A gezeigten Baubahn mit hervorgehobener dritter Sensorgruppe,
- Fig. 3D: eine schematische Darstellung der in Fig. 3A gezeigten Baubahn mit hervorgehobener vierter Sensorgruppe,
- Fig. 3E: eine schematische Darstellung der in Fig. 3A gezeigten Baubahn mit hervorgehobener fünfter Sensorgruppe,
- Fig. 4A: eine schematische Darstellung einer weiteren Ausführungsform einer Baubahn mit hervorgehobener erster Sensorgruppe,
- Fig. 4B: eine schematische Darstellung der in Fig. 4A gezeigten Baubahn mit hervorgehobener zweiter Sensorgruppe,
- Fig. 4C: eine schematische Darstellung der in Fig. 4A gezeigten Baubahn mit hervorgehobener dritter Sensorgruppe,
- Fig. 4D: eine schematische Darstellung der in Fig. 4A gezeigten Baubahn mit hervorgehobener vierter Sensorgruppe,
- Fig. 4E: eine schematische Darstellung der in Fig. 4A gezeigten Baubahn mit hervorgehobener fünfter Sensorgruppe,
- Fig. 5: eine schematische Darstellung einer weiteren Ausführungsform einer Baubahn,
- Fig. 6: eine schematische Querschnittsdarstellung einer erfindungsgemäßen Baubahn,
- Fig. 7: eine schematische Querschnittsdarstellung einer weiter Ausführungsform erfindungsgemäßen Baubahn,
- Fig. 8: eine schematische Seitenansicht einer weiteren Ausführungsform der erfindungsgemäßen Baubahn,
- Fig. 9: eine schematische perspektivische Darstellung einer weiteren Ausführungsform einer erfindungsgemäßen Baubahn,
- Fig. 10: eine schematische Darstellung einer Anschlusseinrichtung,
- Fig. 11: eine schematische Darstellung einer erfindungsgemäßen Teststruktur,
- Fig. 12: eine schematische Darstellung einer weiteren Ausführungsform einer erfindungsgemäßen Baubahn,
- Fig. 13: eine schematische Darstellung eines Ausschnitts einer weiteren Aus-führungsform einer erfindungsgemäßen Baubahn und
- Fig. 14: eine schematische Darstellung einer weiteren Ausführungsform einer erfindungsgemäßen Baubahn.

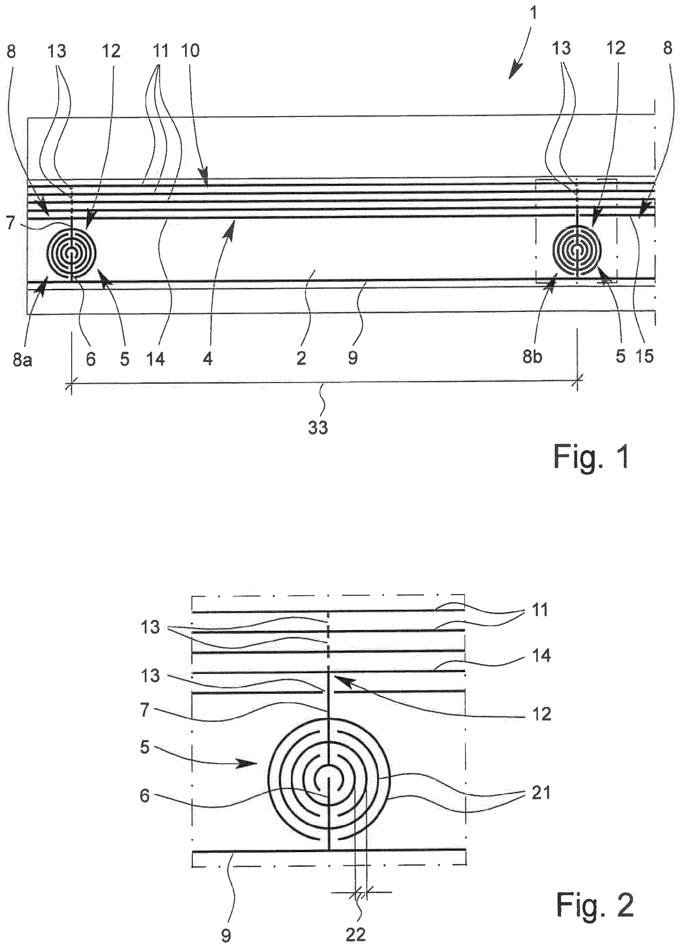

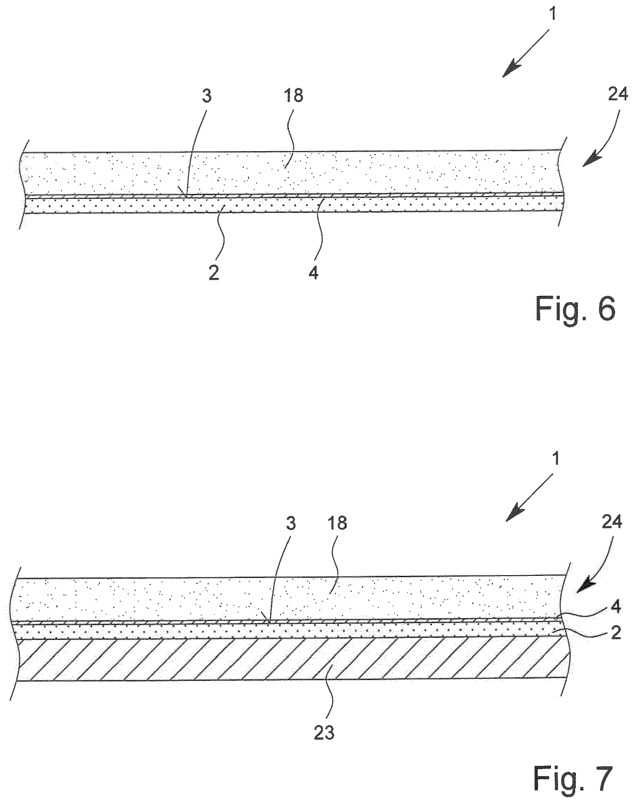

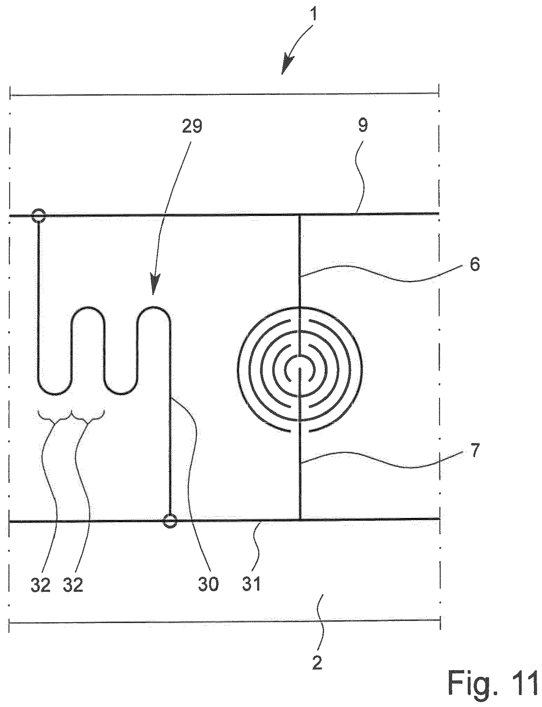

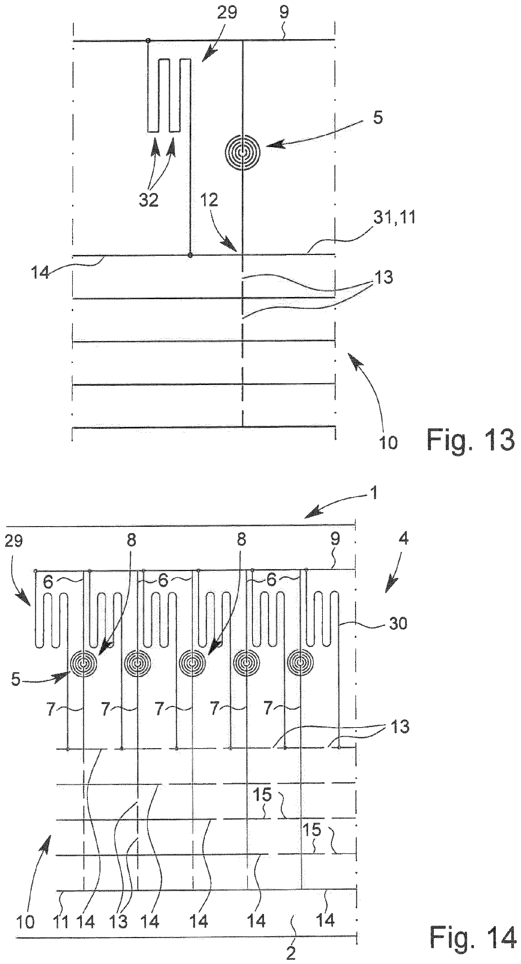

Fig. 11 zeigt eine Baubahn 1, die zur Verwendung als Dachbahn geeignet ist. Die Baubahn 1 weist eine Trägerschicht 2 auf, was jedoch in der Fig. 11 nicht näher dargestellt ist. Diesbezüglich darf insbesondere auf die Fig. 6 und 7 verwiesen werden, die einen entsprechenden Aufbau zeigen. Auf der Außenseite 3 der Trägerschicht 2 ist, wie die Fig. 1 zeigt, eine Elektronikeinheit 4 aufweisend wenigstens einen Feuchtesensor 5 aufgebracht, insbesondere aufgedruckt. Der Feuchtesensor 5 ist zur Feuchtemessung elektrisch mit einer Zuleitung 9 und einer Kontakt-Leiterbahn 31 verbunden, wie dies die Fig. 13 zeigt. Dies ist auch in der Fig. 11 dargestellt.

Zur Funktionsüberprüfung der elektrischen Kontaktierung des Feuchtesensors 5, wie er beispielsweise in Fig. 11 gezeigt ist, ist eine Teststruktur 29 vorgesehen, die mit der Zuleitung 9 und der Kontakt-Leiterbahn 31 elektrisch verbunden ist. In dem dargestellten Ausführungsbeispiels schließt die Teststruktur 29 letztlich die Zuleitung 9 mit der Kontakt-Leiterbahn 31 kurz. Über die Teststruktur 29 kann überprüft werden, ob sowohl die Zuleitung 9 als auch die Kontakt-Leiterbahn 31 mit elektrischer Energie bzw. Strom versorgt werden können und somit eine korrekte Funktionsweise der Feuchtesensoren 5 gewährleistet werden kann.

In Fig. 11 ist dargestellt, dass die Teststruktur 29 parallel zum Feuchtesensor 5 geschaltet ist. Die Teststruktur 29 kann dabei als Testleiterbahnabschnitt 30 ausgebildet sein.

Ein Testleiterbahnabschnitt 30, wie er auch in der Fig. 11 dargestellt ist, zeichnet sich dadurch aus, dass die Teststruktur 29 letztlich durch eine Leiterbahn, nämlich durch einen Testleiterbahnabschnitt, gebildet wird. Auch die Zuleitung 9 und die Kontaktleiterbahn 31 können durch entsprechende Leiterbahnen 11, die alle elektrisch leitfähig sind, gebildet werden.

Nicht näher dargestellt ist, dass die Teststruktur 29 einen elektrischen Widerstand zwischen 0,1 bis 30 MΩ aufweist.

Jedoch zeigt die Fig. 11, dass die Länge des Testleiterbahnabschnittes 30 größer als der Abstand zwischen der Zuleitung 9 und der Kontakt-Leiterbahn 31, bevorzugt um wenigstens das 1,1-fache des vorgenannten Abstands ist. Die Länge des Testleiterbahnabschnittes 30 ergibt sich insbesondere im ausgezogenen Zustand und ist insbesondere die gesamte Weglänge des Testleiterbahnabschnittes 30. Verbindet der Testleiterbahnabschnitt 30 unmittelbar die Zuleitung 9 mit der Kontaktleiterbahn 31 durch eine spezielle Ausrichtung und Anordnung des Testleiterbahnabschnittes 30 kann jedoch die Weglänge des Testleiterbahnabschnittes 30 erhöht werden, wodurch der Abstand zwischen Zuleitung 9 und Kontakt-Leiterbahn 31 überschritten werden kann.

Hierzu weist bei der in Fig. 11 dargestellten Ausführungsform die Teststruktur 29 eine Mehrzahl von Windungen 32 auf. Je nach Ausführungsform kann wenigstens eine Windung oder zwischen 2 bis 20 Windungen 32 vorgesehen sein. Die Windungen können gerundet ausgebildet sein, wie dies die Fig. 11 zeigt. In Fig. 13 ist eine alternative Ausführungsform dargestellt, bei der die Windungen 32 eckig ausgebildet sind.

Die in Fig. 11 dargestellte Teststruktur 29 verläuft mäanderförmig, wodurch sich der Widerstand gegenüber einen geradlinigen Testleiterbahnabschnitt 30 erhöht, was zur Durchführung der Funktionsüberprüfung besonders vorteilhaft ist.

Die Fig. 1 bis 5 zeigen eine Baubahn 1 ohne Teststruktur 29. Die diesbezügliche Baubahn 1 kann aber in gleicher Weise wenigstens eine Teststruktur 29 aufweisen. Die nachfolgenden Ausführungen zu den in den Fig. 1 bis 5 und auch in den übrigen Figuren gezeigten Ausführungsformen der Baubahn 1 sind somit insbesondere auch auf eine erfindungsgemäße Baubahn 1 mit Teststruktur 29 übertragbar, ohne dass dies weiterer Ausführungen bedarf.

Fig. 1 zeigt eine Baubahn 1. Die Baubahn 1 kann insbesondere im Flachdachbereich und/oder innerhalb einer Unterbedachung verwendet werden. Ferner zeigt Fig. 1, dass die Baubahn 1 eine Trägerschicht 2 aufweist, die in einem Schichtaufbau 24 integriert ist. Der Schichtaufbau 24 kann einschichtig oder mehrschichtig ausgebildet sein. Bei dem in Fig. 1 dargestellten Ausführungsbeispiel ist ein wenigstens zweischichtiger Schichtaufbau 24 vorgesehen.

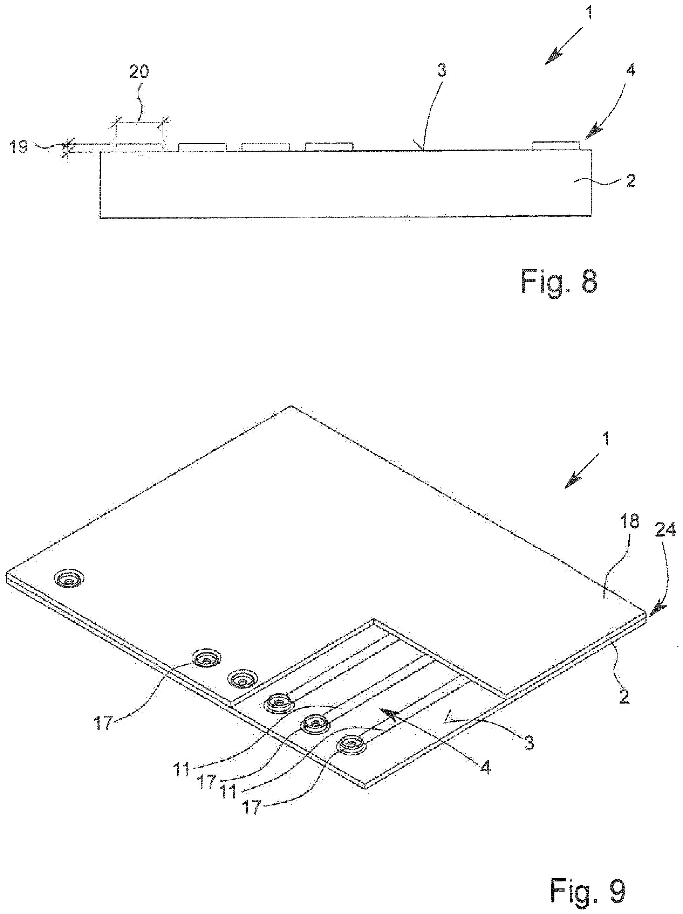

Fig. 8 zeigt eine einschichtige Baubahn 1. Die Trägerschicht 2 weist eine Elektronikeinheit 4 auf.

Fig. 6 zeigt eine Baubahn 1 mit einem mehrlagigen Schichtaufbau 24. Der Schichtaufbau 24 weist eine Trägerschicht 2 und eine Textilschicht 18 auf. Auf die Außenseite 3 der Trägerschicht 2 ist eine Elektronikeinheit 4 aufgebracht, insbesondere aufgedruckt.

In weiteren Ausführungsformen kann die Baubahn 1 auch ohne eine Textilschicht 18 bereitgestellt werden.

Fig. 1 zeigt, dass die aufgedruckte Elektronikeinheit 4 einen Feuchtesensor 5 aufweist.

Fig. 2 zeigt ein Detail der Fig. 1. Der in Fig. 2 dargestellte Feuchtesensor 5 ist als resistiver Feuchtesensor 5 ausgebildet. Zur resistiven Feuchtemessung weist der Feuchtesensor 5 wenigstens zwei benachbarte elektrisch leitfähige Messleiterbahnen 6, 7 auf. Die Messleiterbahnen 6, 7 bilden im dargestellten Ausführungsbeispiel ein gerundetes, insbesondere zumindest im Wesentlichen kreisförmiges, Sensorfeld aus. Das dargestellte Sensorfeld ist zumindest im Wesentlichen labyrinthartig aufgebaut.

Nicht näher dargestellt ist, dass der Feuchtesensor 5 mit den zwei Messleiterbahnen 6, 7 auch als kapazitiver Feuchtesensor 5 ausgebildet sein kann. Auch zur kapazitiven Feuchtemessung können die elektrisch leitfähigen Messleiterbahnen 6, 7 genutzt werden. Bei einer Ausbildung des Feuchtesensors 5 als kapazitiver Feuchtesensor 5 kann ein wie in Fig. 2 dargestelltes Design des Feuchtesensors 5 genutzt werden. Auch ein kapazitiver Feuchtesensor 5 kann auf die Außenseite 3 der Trägerschicht 2 aufgebracht, insbesondere aufgedruckt, sein.

Fig. 2 zeigt weiter, dass die zwei Messleiterbahnen 6, 7 des Feuchtesensors 5 miteinander kämmen. Zudem bilden die dargestellten Messleiterbahnen 6, 7 eine Mehrzahl von abstehenden Fingern 21 aus. Die Finger 21 greifen im Ausführungsbeispiel der Fig. 2 ineinander und kämmen miteinander. Die Finger 21 sind darüber hinaus zumindest im Wesentlichen bogenabschnittsförmig, insbesondere kreisbogenabschnittsförmig, ausgebildet. Zwischen zwei unmittelbar benachbarten Fingern 21 wird eine Wasserleitung ausgebildet, also ein Bereich, der bei Undichtigkeit Wasser oder Feuchtigkeit führen kann.

Zudem zeigt Fig. 2, dass die gebildeten Wasserleitungen eine zumindest im Wesentlichen gerundete Form aufweisen und insbesondere zumindest im Wesentlichen kreisringabschnittsförmig ausgebildet sind. Eine Wasserleitung kann dabei insbesondere die Form eines halben Kreisringes oder auch nur Bereiche davon ausbilden.

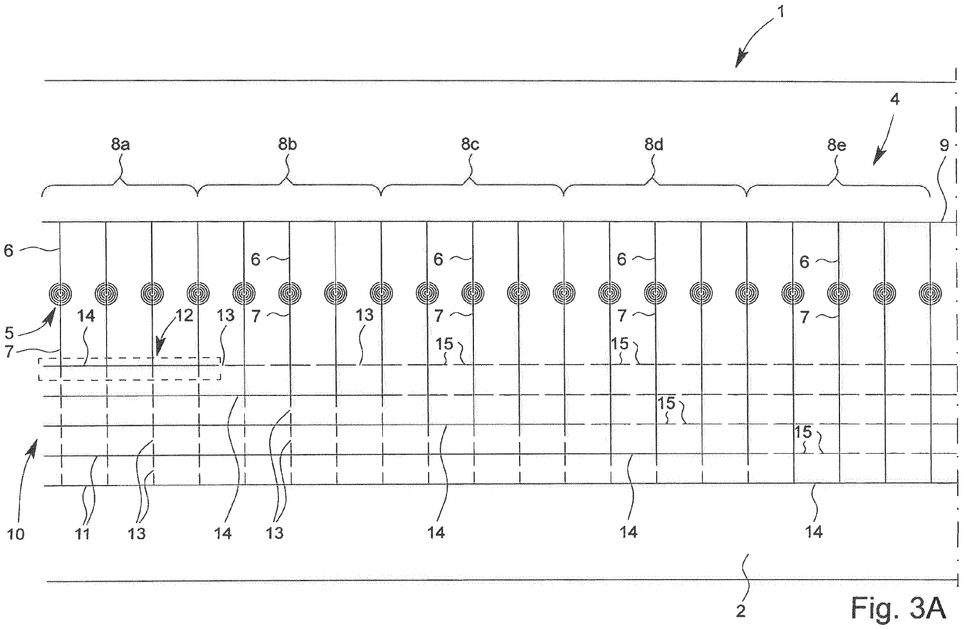

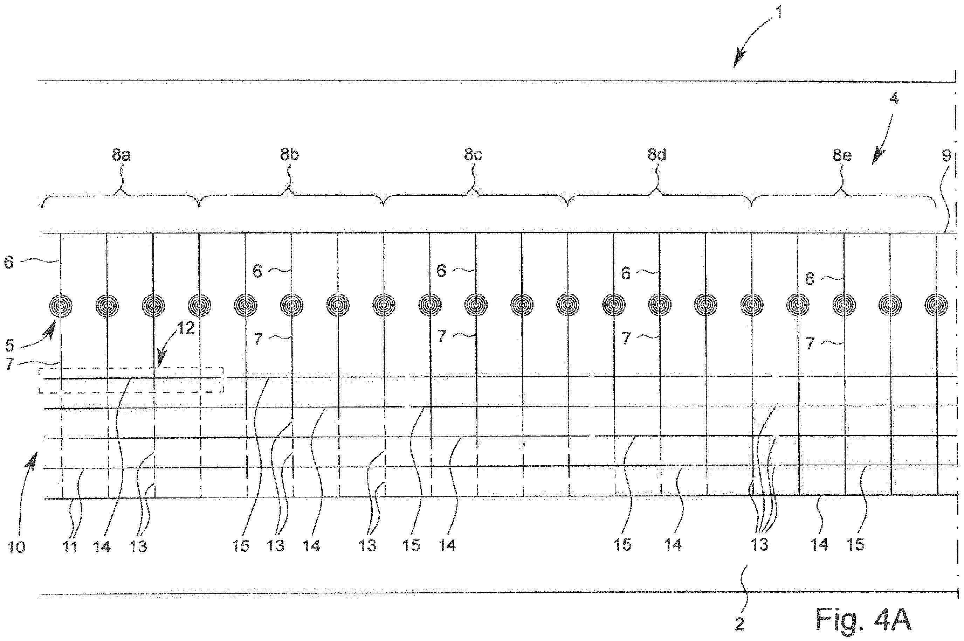

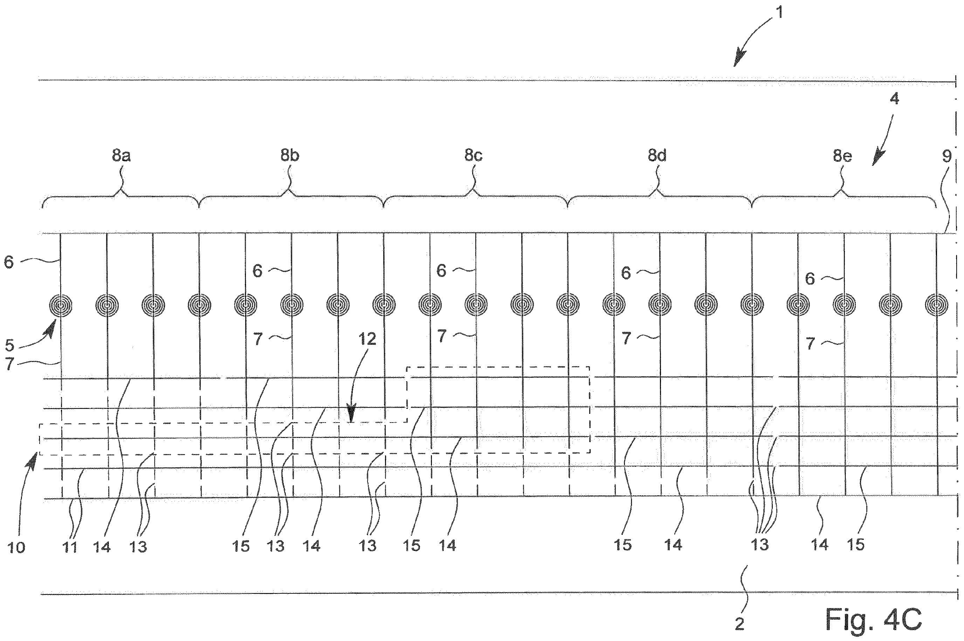

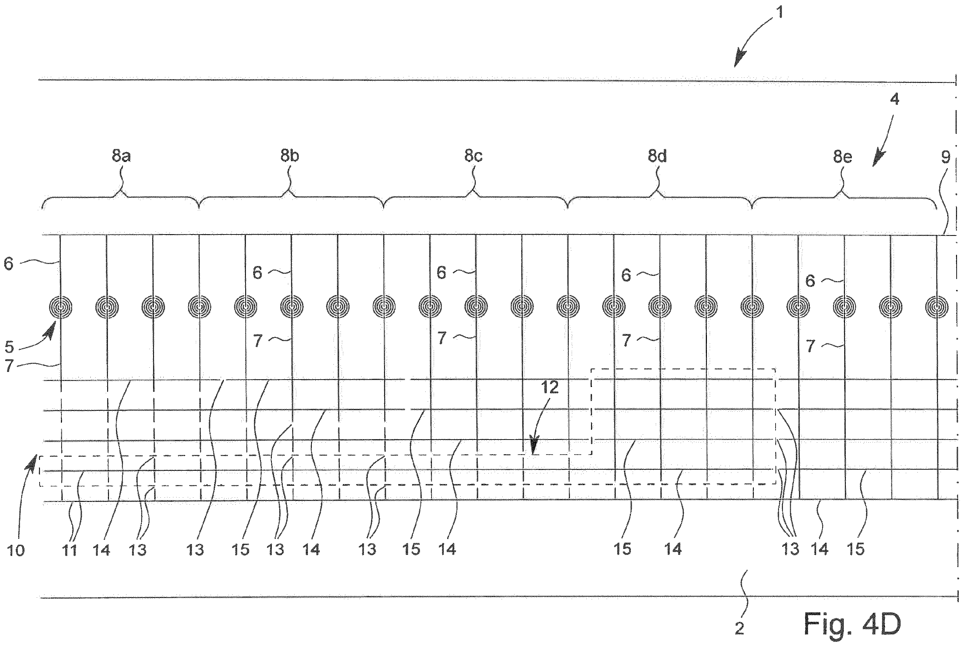

Die Fig. 3A bis 3E sowie die Fig. 4A bis 4E zeigen eine Mehrzahl von Sensorgruppen 8a-8e. Die Sensorgruppen 8a-8e können durch wenigstens einen Feuchtesensor 5, in den dargestellten Ausführungsbeispielen durch mehrere Feuchtesensoren 5, gebildet sein.

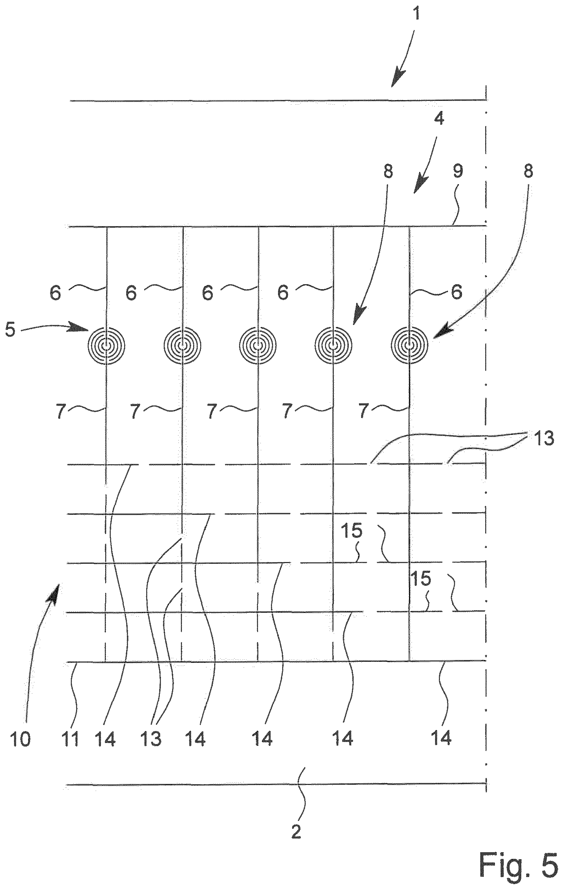

Die Fig. 1 zeigt, dass Sensorgruppen 8a-8e vorgesehen sind, die jeweils nur einen Feuchtesensor 5 umfassen. Dies ist beispielsweise auch in der Fig. 5 gezeigt, wo jede Sensorgruppe 8 nur einen Feuchtesensor 5 umfasst.

Nicht näher dargestellt ist, dass unterschiedliche Sensorgruppen 8 auch eine unterschiedliche Anzahl von Feuchtesensoren 5 umfassen können. Die Fig. 3A zeigt, dass die erste Messleiterbahn 6 des Feuchtesensors 5 mit wenigstens einer Zuleitung 9 elektrisch verbunden ist. In dem in Fig. 3A dargestellten Ausführungsbeispiel sind alle ersten Messleiterbahnen 6 aller Feuchtesensoren 5 bzw. alle ersten Messleiterbahnen 6 der Sensorgruppen 8a bis 8e mit einer Zuleitung 9 elektrisch verbunden sind.

Außerdem zeigt die Ausführungsform nach der Fig. 3A, aber auch die Ausführungsform nach der Fig. 4A, dass die zweite Messleiterbahn 7 des Feuchtesensors 5 mit einer einer Mehrzahl von Leiterbahn 11 aufweisenden Leitungseinrichtung 10 elektrisch verbunden ist. Die Leitungseinrichtung 10 ist in den Ausführungsbeispielen, wie auch aus Fig. 5 ersichtlich wird, durch eine Mehrzahl von Leiterbahnen 11 gebildet.

In den dargestellten Ausführungsbeispielen verlaufen die Leiterbahnen 11 insbesondere parallel zueinander und weiter bevorzugt in Längsrichtung der Baubahn 1. Zumindest ein Bereich der zweiten Messleiterbahn 7 kann insbesondere orthogonal zu den Leiterbahnen 11 angeordnet sein, wie dies auch aus der Fig. 5 ersichtlich wird.

Die Fig. 3A und die Fig. 4A zeigen bei unterschiedlichen Ausführungsformen, dass jeder Sensorgruppe 8a-8e eine mit der zweiten Messleiterbahn 7 des jeweiligen Feuchtesensors 5 der jeweiligen Sensorgruppe 8a-8e elektrisch verbundene Leitungseinheit 12 der Leitungseinrichtung 10 zugeordnet ist, wobei die einzelnen Leitungseinheiten 12 elektrisch voneinander über wenigstens eine Trennstelle 13 und/oder Trennstellen 13 getrennt sind.

In den dargestellten Ausführungsbeispielen ist eine Mehrzahl von Trennstellen 13 vorgesehen. Die Fig. 5 zeigt die Trennstellen 13 für Sensorgruppen 8, die nur einen Feuchtesensor 5 umfassen, was ebenfalls auch in Fig. 1 für zwei Feuchtesensoren 5 und somit für zwei Sensorgruppen 8 dargestellt ist.

Ferner sind in den dargestellten und bevorzugten Ausführungsbeispielen die Trennstellen 13 sowohl in den jeweiligen Leiterbahnen 11 als auch in den jeweiligen zweiten Messleiterbahnen 7 eingebracht.

In Fig. 1 ist dargestellt, dass die Trennstelle 13 als Unterbrechung der Leiterbahn 11 und der zweiten Messleiterbahn 7 ausgebildet ist. Eine Trennstelle 13 kann insbesondere entweder als Unterbrechung der Leiterbahn 11 oder als Unterbrechung der zweiten Messleiterbahn 7 ausgebildet sein, so dass insbesondere letztlich zwei unterschiedliche Arten von Trennstellen 13 realisiert sein können. Die Trennstellen 13 in ein und derselben zweiten Messleiterbahn 7 können unterschiedliche Abschnitte der zweiten Messleiterbahn 7 voneinander elektrisch trennen und insbesondere eine Kontaktierung zu dem Feuchtesensor 5 unterbrechen.

Die Fig. 3A zeigt, dass die Feuchtesensoren 5 einer Sensorgruppe 8a bis 8e parallel geschaltet sind, insbesondere sofern mehrere Feuchtesensoren 5 in einer Sensorgruppe 8a-8e eingesetzt werden.

In den Ausführungsformen nach den Fig. 3A und 4A, aber auch in der Ausführungsform nach der Fig. 5 ist dargestellt, dass wenigstens eine Leiterbahn 10 einen mit einer nicht näher dargestellten elektrischen Verbindungseinrichtung der Baubahn 1 verbindbaren Hauptleiterbahnabschnitt 14 und wenigstens einen von dem Hauptleiterbahnabschnitt 14 dieser Leiterbahn 11 über eine Trennstelle 13 getrennten Nebenleiterbahnabschnitt 15 aufweist. Insbesondere weist die wenigstens eine Leiterbahn 11 eine Mehrzahl von Nebenleiterabschnitten 15 auf, wobei die Nebenleiterbahnabschnitte 15 der jeweiligen Leiterbahn 11 voneinander jeweils durch wenigstens eine, bevorzugt in der Leiterbahn 11 vorgesehene, Trennstelle 13 getrennt sind.

In den Fig. 3A bis 3E sind letztlich durch entsprechende gestrichelte Hervorhebungen unterschiedliche Leitungseinheiten 12 dargestellt. Die Fig. 3A zeigt zum Beispiel, dass die Leitungseinheit 12 für die Sensorgruppe 8a nur einen Hauptleiterbahnabschnitt 14 einer Leiterbahn 11 umfasst. Dieser Hauptleiterbahnabschnitt 14 ist über Trennstellen 13 in den zweiten Messleiterbahnen 7 der Feuchtesensoren 5 dieser Sensorgruppe 8a zu anderen Leiterbahnen 11 unterbrochen. Somit umfasst die Leitungseinrichtung 12 für die Sensorgruppe 8a keinen Nebenleiterbahnabschnitt 15.

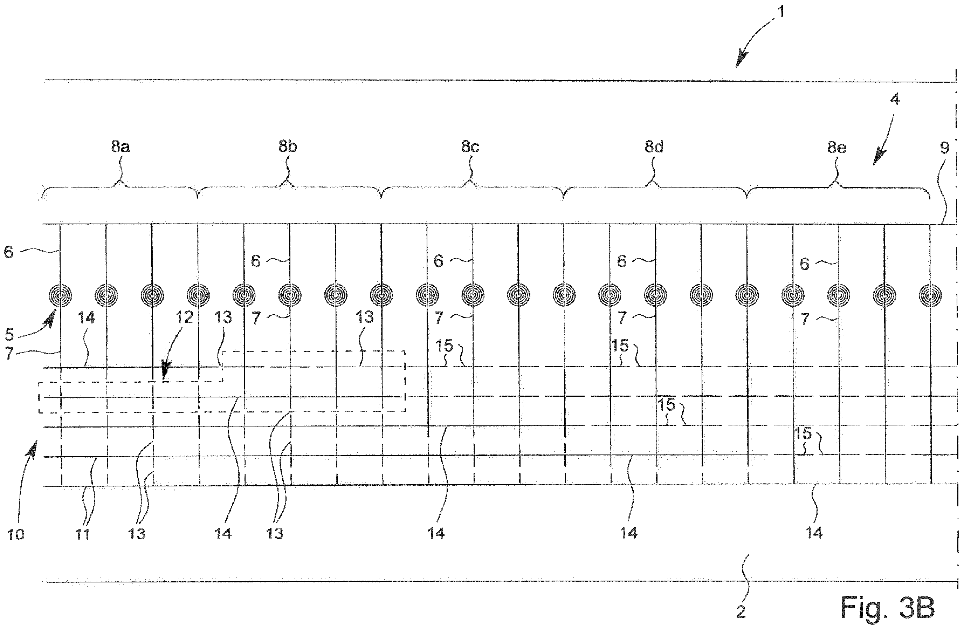

In Fig. 3B ist dargestellt, dass der Hauptleiterbahnabschnitt 14 letztlich durch eine andere Leiterbahn 11 gebildet wird, wobei gleichzeitig auch die Sensorgruppe 8e eine Mehrzahl von Nebenleiterabschnitten 15 der ersten Leiterbahn 11 für die Sensorgruppe 8a aufweist.

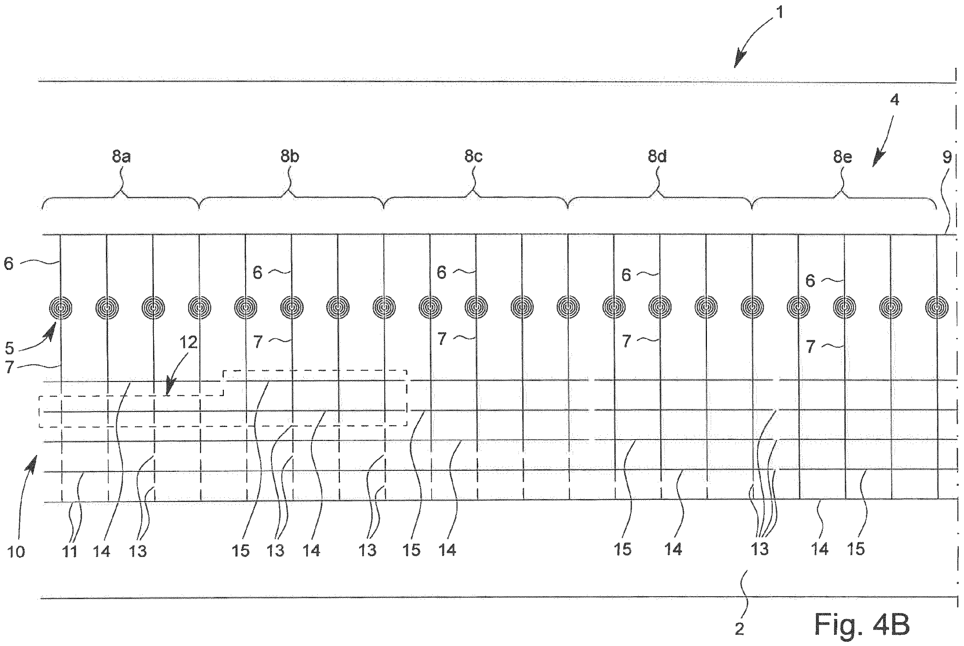

In Fig. 4B ist wiederum die Alternative dargestellt, dass die erste Leiterbahn 11 nur einen Nebenleiterbahnabschnitt 15 für die Sensorgruppe 8b aufweist. Zu den anderen Leiterbahnen 11 ist die Leitungseinheit 12 durch Trennstellen 13 sowohl in der Leiterbahn 11 als auch in den zweiten Messleiterbahnen 7 der Sensorgruppe 8b getrennt.

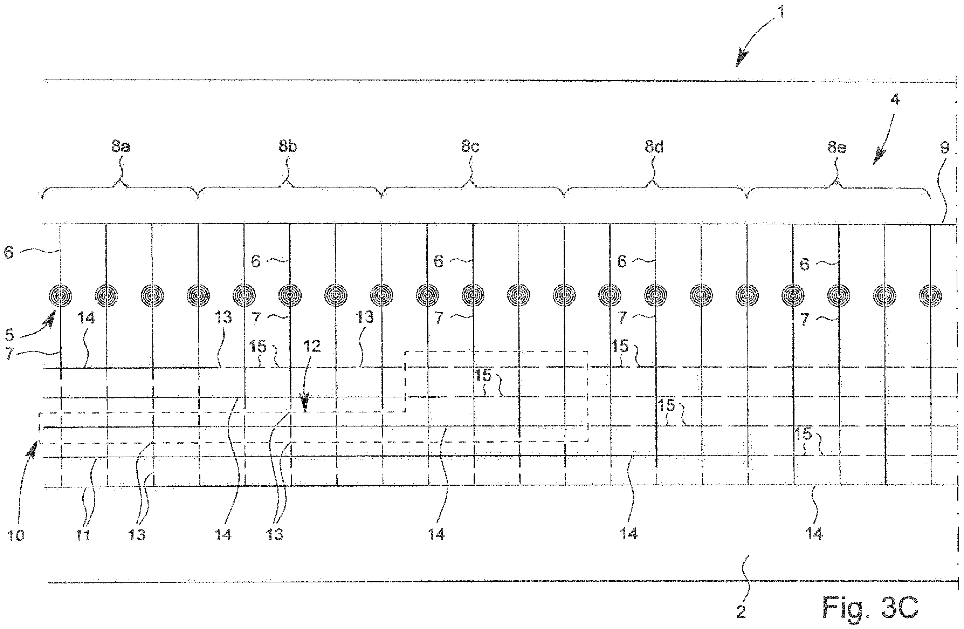

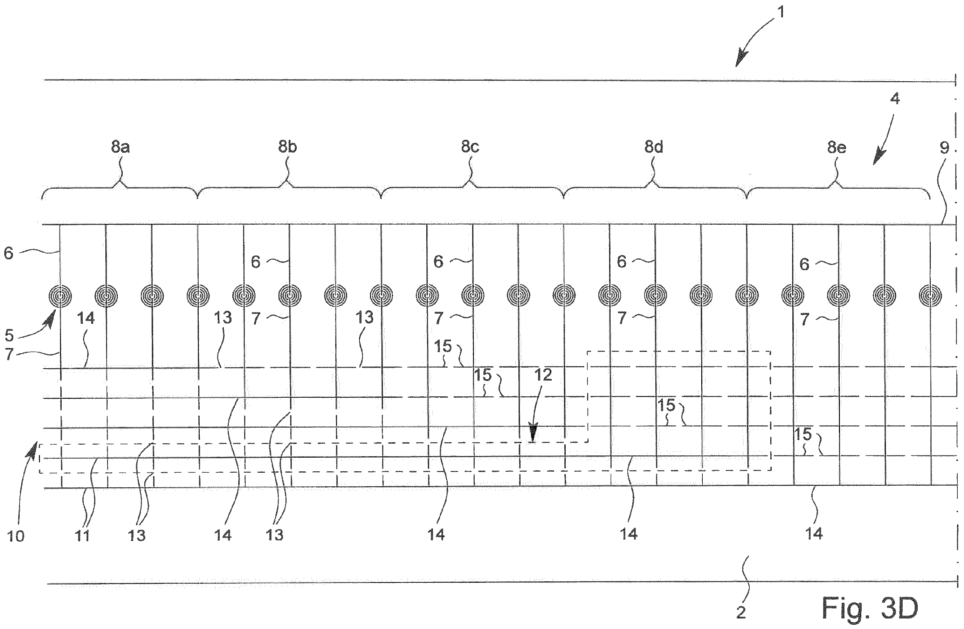

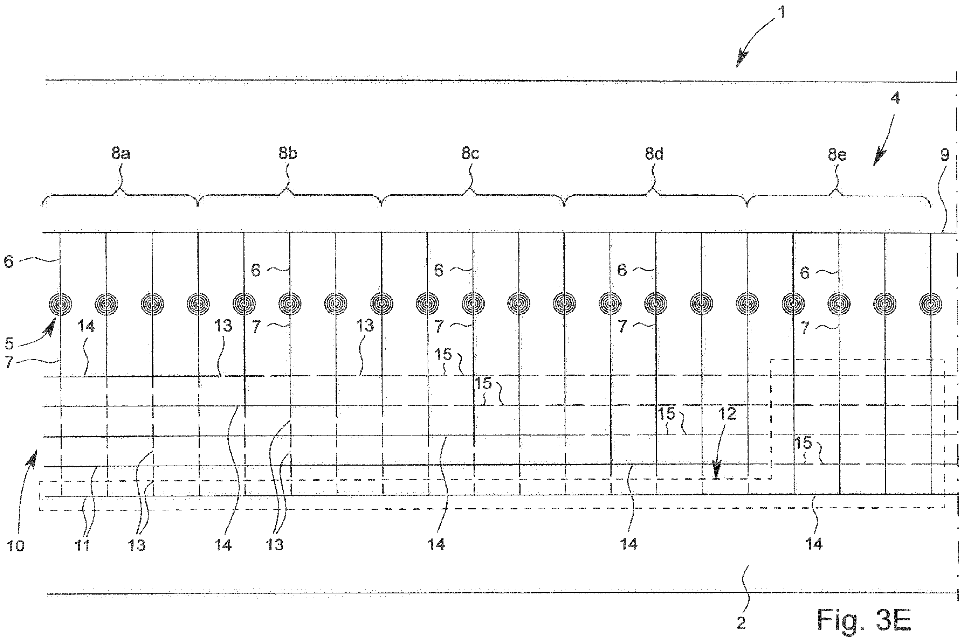

In Fig. 3C wiederum ist die Leitungseinheit 12 für die Sensorgruppe 8c, in Fig. 3D für die Sensorgruppe 8d sowie in Fig. 3E für die Sensorgruppe 8e dargestellt. Die entsprechenden Hervorhebungen der Leitungseinheiten 12 verdeutlichen, dass für unterschiedliche Sensorgruppen 8a-8e letztlich auch unterschiedliche ausgebildete Leitungseinheiten 12 vorgesehen sind, die voneinander über Trennstellen 13 getrennt sind. Diese unterschiedlichen Leitungseinheiten 12 ermöglichen es insbesondere bei einem wiederkehrenden Muster des gesamten unteren Kontaktierungsbereiches der Elektronikeinheit 4 (der durch den orthogonalen Abschnitt der zweiten Messleiterbahnen 7 und den parallelen Leiterbahnen 11 gebildet wird), eine entsprechende Kontaktierung für die unterschiedlichen Sensorgruppen 8a-8e bereitzustellen.

Die Ausführungsform nach der Fig. 4A bis 4D unterscheidet sich von der in Fig. 3A bis 3D dargestellten Ausführungsform durch eine unterschiedliche Ausbildung der Nebenleiterbahnabschnitte 15 im Bereich einer Sensorgruppe 8a-8e.

Folglich kann also eine Leiterbahn 11 eine Mehrzahl von Nebenleiterbahnabschnitten 15 aufweisen, wobei die Nebenleiterbahnabschnitte 15, wie in Fig. 4A gezeigt, der jeweiligen Leiterbahn 11 voneinander jeweils durch wenigstens eine in der Leiterbahn 11 vorgesehene Trennstelle 13 getrennt sind.

Die in den Fig. 3A bis 3E sowie in den Fig. 4A bis 4E dargestellten Leitungseinheiten 12 sind gemäß den vorgenannten Ausführungen durch einen Hauptleiterbahnabschnitt 14 der Leiterbahn 11 und wenigstens einen Nebenleiterbahnabschnitt 15 wenigstens einer anderen Leiterbahn 11 gebildet.

Wenigstens eine Messleiterbahn 7 eines Feuchtesensors 5 einer jeweiligen Sensorgruppe 8a-8e kann elektrisch mit dem Hauptleiterbahnabschnitt 14 der zugeordneten Leitungseinheit 12 verbunden sein, was für die unterschiedlichen Sensorgruppen 8a-8e jeweils in den Ausführungsformen nach den Fig. 3A bis 3E sowie in den Ausführungsformen nach den Fig. 4A bis 4E dargestellt ist. Die zweiten Messleiterbahnen 7 kreuzen insbesondere wenigstens einen Nebenleiterbahnabschnitt 15 der zugeordneten Leitungseinheit 12 und sind elektrisch mit diesem verbunden, wobei die zweite Messleiterbahn 7 von wenigstens einem Hauptleiterbahnabschnitt 14 einer anderen Leitungseinheit 12 durch wenigstens eine Trennstelle 13 in der zweiten Messleiterbahn 7 elektrisch getrennt ist.

Wie zuvor erläutert, zeigen die Fig. 3A bis 3E und Fig. 4A bis 4E unterschiedliche Ausführungsformen. Gemäß den Fig. 3A bis 3E ist vorgesehen, dass ein Nebenleiterbahnabschnitt 15 einer Leitungseinheit 12 wenigstens (in den dargestellten Ausführungsformen nur) eine zweite Messleiterbahn 7 der der Leitungseinheit 12 zugeordneten Sensorgruppe 8a-8e kreuzt und elektrisch mit dieser verbunden ist.

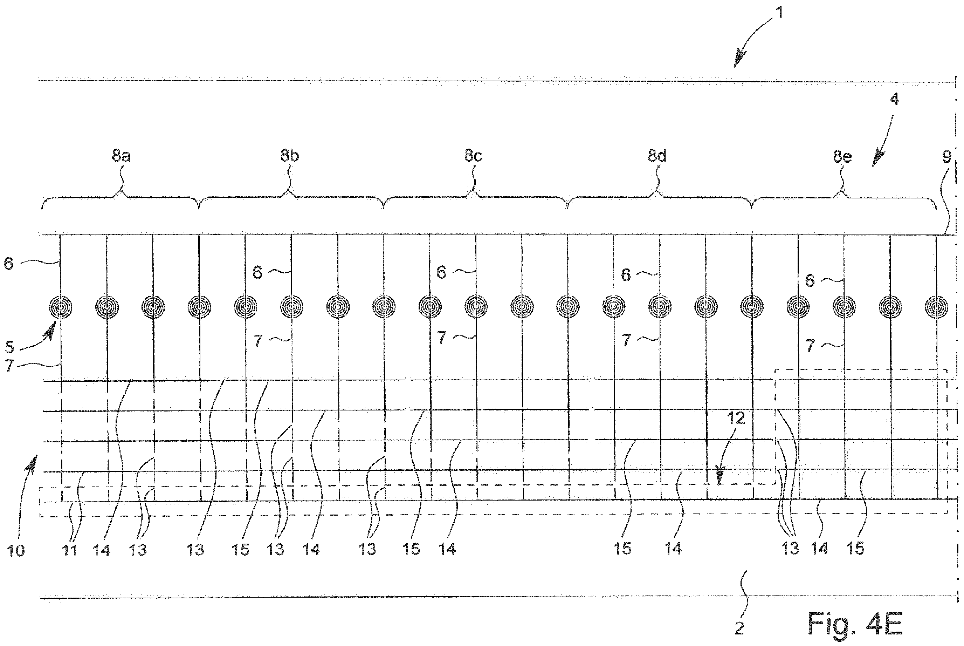

In den Fig. 4A und 4E wird die bevorzugte Ausführungsform dargestellt, dass ein Nebenleiterbahnabschnitt 15 einer Leitungseinheit 12 alle zweiten Messleiterbahnen 7 der der Leitungseinheit 12 zugeordneten Sensorgruppe 8a-8e kreuzt und elektrisch mit diesen verbunden ist.

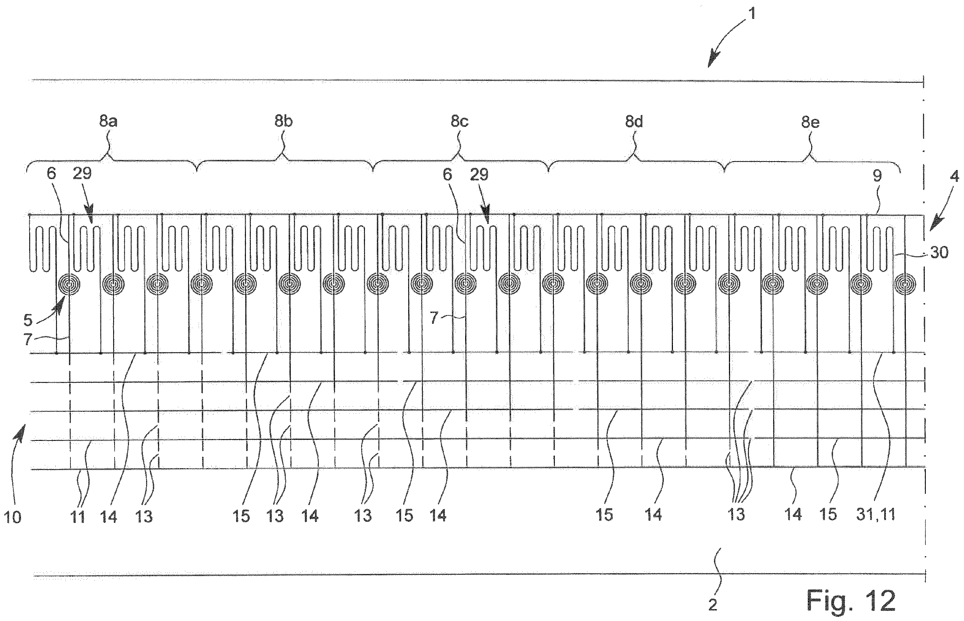

Diese Ausführungsform ist insbesondere für Baubahnen 1 mit Teststruktur 29 sinnvoll. Wie die Fig. 12 zeigt, ist bei Sensorgruppen 8a-8e mit mehreren Feuchtesensoren 5 besonders bevorzugt vorgesehen, dass die Teststruktur 29 entweder mit dem Hauptleiterbahnabschnitt 14 (s. Sensorgruppe 8a) oder den am nächsten liegenden Nebenleiterbahnabschnitt 15 unmittelbar elektrisch verbunden ist, wobei alle zweiten Messleiterbahnen 7 mit denselben Nebenleiterbahnabschnitten 15 der Leitungseinheit 12 verbunden sind. Zumindest sind alle zweiten Messleiterbahnen 7 einer Sensorgruppe 8b-8e unmittelbar mit demjenigen Nebenleiterbahnabschnitt 15, der zu der Teststruktur 29 und der Zuleitung 9 am nächsten angeordnet ist, elektrisch verbunden.

Grundsätzlich kann auch eine Kombination der vorgenannten Ausführungen erfolgen, sofern dies anwendungsseitig bevorzugt ist.

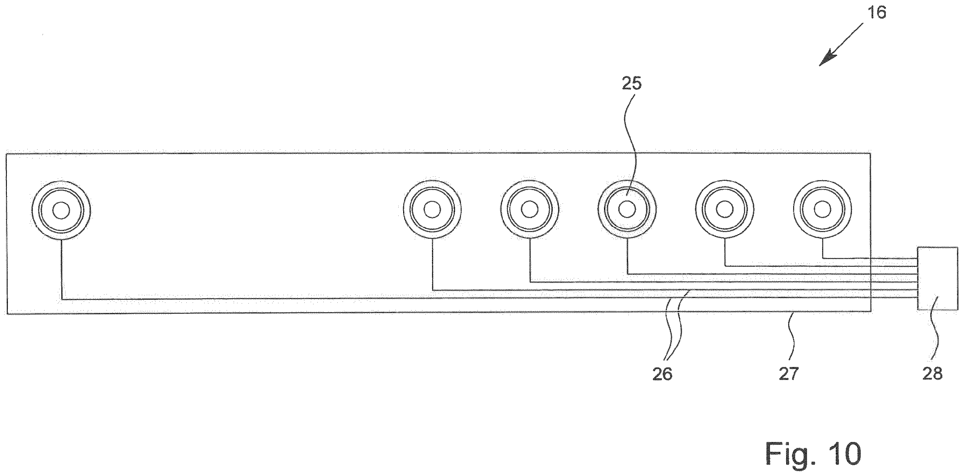

In der Fig. 9 ist dargestellt, dass ein erstes Verbindungsmittel 17 der Verbindungseinrichtung der Baubahn 1 vorgesehen ist. Dieses erste Verbindungsmittel 17 verbindet nämlich die Hauptleiterbahnabschnitte 14 und/oder die Zuleitung 9 zu einer externen Anschlusseinrichtung 16, insbesondere elektrisch. Die externe Anschlusseinrichtung 16 ist mit einer schematischen Ausführungsform in der Fig. 10 dargestellt. Die elektrische Verbindung zwischen der Anschlusseinrichtung 16, die wiederum über ein Energieversorgungsmittel 28 zu einer Stromversorgung verbunden werden kann, gewährleistet insbesondere die sichere elektrische Kontaktierung der Feuchtesensoren 5.

In Fig. 10 ist schematisch eine externe Anschlusseinrichtung 16 dargestellt, die mit den ersten Verbindungsmitteln 17 der in Fig. 1 dargestellten Baubahn 1 verbunden werden kann.

Ferner zeigen die Fig. 9 und 10 ebenfalls eine komplementäre Ausbildung des ersten Verbindungsmittels 17 zu den zweiten Verbindungsmittel 25 der externen Anschlusseinrichtung 9. So kann das erste Verbindungsmittel 17 komplementär zu einem zweiten Verbindungsmittel 25 der externen Anschlusseinrichtung 16 ausgebildet sein, wobei das erste Verbindungsmittel 17 den elektrischen Kontakt zwischen dem zweiten Verbindungsmittel 25 der externen Anschlusseinrichtung 16 und der Elektronikeinheit 4 der Baubahn 1 bereitstellen kann.

Bei dem in den Fig. 9 und 10 dargestellten Ausführungsbeispiel ist vorgesehen, dass das erste Verbindungsmittel 7 als Verbindungsmittel eines komplementären, vorzugsweise zerstörungsfrei und/oder werkzeuglos lösbaren, Verbindungssystems ausgebildet ist. In dem dargestellten Ausführungsbeispiel ist als Verbindungssystem eine Druckknopfverbindung vorgesehen. Die Druckknopfverbindung weist insbesondere eine geringe Aufbauhöhe auf. So kann die Aufbauhöhe des ersten Verbindungsmittels 17, das mit dem zweiten Verbindungsmittel 25 verbunden ist, insbesondere eine Höhe von 1 cm nicht überschreiten.

Letztlich kann das erste Verbindungsmittel 17 mit dem zweiten Verbindungsmittel 25 formschlüssig und/oder verrastbar verbindbar.

Bevorzugt kann jeder Leiterbahn 11 und/oder jedem Hauptleiterbahnabschnitt 15 ein eigenes Verbindungsmittel 17 zur Strom- bzw. Energieversorgung zugeordnet sein, das wiederrum mit einem zweiten Verbindungsmittel 25 einer externen Anschlusseinrichtung verbunden werden kann.

In Fig. 10 ist dargestellt, dass das zweite Verbindungsmittel 25 der Anschlusseinrichtung 16 in einem Gehäuse 27 angeordnet ist. Das Gehäuse 27 kann als Widerlager dienen, das bei der Herstellung der Verbindung zwischen dem ersten und dem zweiten Verbindungsmittel 17, 25 benötigt wird. Über das Gehäuse 27 kann der zum Zusammenbringen bzw. Verrasten der Verbindungsmittel 17, 25 benötigte Gegendruck bereitgestellt werden.

Die externe Anschlusseinrichtung 16 kann ferner Leitungskabel 26 (die als Leiterbahnen ausgebildet sein können) aufweisen, die jeweils mit dem zweiten Verbindungsmitteln 25 elektrisch kontaktierend verbunden sind. Die Leitungskabel können, wie aus Fig. 10 ersichtlich wird, mit einem Energieversorgungsmittel 28 verbunden sein. Das Energieversorgungsmittel 28 kann bevorzugt an das Stromnetz, eine Batterie und/oder an eine andere externe Stromversorgung anschließbar sein.

Nicht näher dargestellt ist, dass die Zuleitung 9, die Teststruktur 29, die Leitungseinrichtung 10 und/oder die die Leiterbahnen 11 der Leitungseinrichtung 10 auf die Außenseite 3 der Trägerschicht 2 aufgebracht, insbesondere aufgedruckt, sind. Die Trennstellen 13 können nach Aufbringen, insbesondere Aufdrucken, der Elektronikeinheit 4 herstellbar sein.

In der Fig. 3A ist dargestellt, dass wenigstens eine Sensorgruppe 8a-8e, in der dargestellten Ausführungsform alle Sensorgruppen 8a-8e, eine Mehrzahl von Feuchtesensoren 5 aufweist. Insbesondere können zwischen 2 bis 20 Feuchtesensoren 5 je Sensorgruppe 8a-8e eingesetzt werden. Es kann auch vorgesehen sein, dass sich mehreren Sensorgruppen 8a-8e einer Baubahn 1 voneinander durch eine unterschiedliche Anzahl von Feuchtesensoren 5 unterschieden.

Unter anderem in Fig. 3A ist schematisch dargestellt, dass über die Länge der Baubahn 1 eine Mehrzahl von Feuchtesensoren 6 vorgesehen ist. In weiteren Ausführungsformen kann vorgesehen sein, dass die Feuchtesensoren 6 zueinander gleich beabstandet sind.

Der Abstand zwischen zwei unmittelbar benachbarten Feuchtesensoren 6 kann zwischen 10 cm bis 5 m liegen. Bei dem in Fig. 1 dargestellten Ausführungsbeispiel ist vorgesehen, dass der Abstand zumindest im Wesentlichen 40 cm +/- 10 cm beträgt.

Die in Fig. 6 dargestellte Trägerschicht 2 ist wasserdicht ausgebildet. Die Trägerschicht 2 kann insbesondere als wasserdichte Folienschicht ausgebildet sein. Die Trägerschicht 2 kann ferner als Material einen Kunststoff, wie Polypropylen, Polyethylen und/oder Polyethylenterephthalat (PET), aufweisen und/oder daraus bestehen.

Nicht dargestellt ist, dass die Trägerschicht 2 in weiteren Ausführungsformen wasserdicht und/oder diffusionsoffen, insbesondere wasserdampfdurchlässig, und/oder atmungsaktiv ausgebildet ist.

In dem in Fig. 6 dargestellten Ausführungsbeispiel ist vorgesehen, dass die Trägerschicht 2 diffusionsdicht ausgebildet ist. In weiteren Ausführungsformen kann vorgesehen sein, dass die Trägerschicht 2 diffusionshemmend und/oder wasserdampfundurchlässig ausgebildet ist.

Das in Fig. 2 gebildete Sensorfeld des Feuchtesensors 5 kann einen Durchmesser bzw. eine maximale Erstreckung zwischen 3 bis 8 cm aufweisen.

Die Breite der Wasserleitung bzw. der Abstand 22 zwischen zwei unmittelbar benachbarten Fingern 21 kann zwischen 1 mm bis 20 mm betragen.

In den Fig. 6 und 7 ist dargestellt, dass ein mehrlagiger Schichtaufbau 24 vorgesehen ist, da neben der Trägerschicht 2 auch eine wasserdurchlässige, vorzugsweise wasseraufnehmende, Textilschicht 18 vorgesehen sein kann.

Die in den Fig. 6 und 7 dargestellte Textilschicht 18 ist wasseraufnehmend und somit wasserdurchlässig ausgebildet. Die Elektronikeinheit 4 ist zwischen der Trägerschicht 2 und der hydrophilen Textilschicht 18 vorgesehen. Somit ist die Außenseite 3 der Textilschicht 18 zugewandt. Schematisch ist in Fig. 9 dargestellt, dass der Feuchtesensor 5 (abgedeckt durch die Textilschicht 18) im unmittelbaren Kontakt mit der Textilschicht 18 steht. In Fig. 9 ist der Feuchtesensor 5 in der Elektronikeinheit 4 integriert und nicht näher dargestellt, wobei der Feuchtesensor 5 sowie die Elektronikeinheit 4 an der Textilschicht 18 angeordnet sind.

Nicht dargestellt ist, dass die Textilschicht 18 als Vliesschicht ausgebildet ist und insbesondere hydrophile Fasern aufweist. Als hydrophile Fasern können insbesondere Fasern vorgesehen sein, die als Material Polyethylenterephthalat (PET) aufweisen. Alternativ oder zusätzlich kann vorgesehen sein, dass die Fasern der Textilschicht 18 eine hydrophile Beschichtung aufweisen.

Nicht näher dargestellt ist, dass die Textilschicht 18 im mittelbaren und/oder unmittelbaren Kontakt zu der Elektronikeinheit 4 und den Feuchtesensoren 5 ist. Der Kontakt ist insbesondere derart, dass die Feuchtesensoren 5 eine Feuchtigkeit, die in der Trägerschicht 2 in wenigstens einer Wasserleitung aufgenommen worden ist, detektieren kann. Ein mittelbarer Kontakt zwischen Textilschicht 18 und Elektronikeinheit 4 kann sich dann ergeben, wenn zur Verbindung der Textilschicht 4 mit der Trägerschicht 2 eine Klebeschicht zwischen der Elektronikeinheit 4 und der Textilschicht 18 zur stoffschlüssigen Verbindung vorgesehen ist. Über die Kleberschicht kann jedoch trotzdem eine Feuchtedetektion ermöglicht werden, so dass die Feuchtemessung letztlich insbesondere nicht beeinträchtigt wird. Die Fig. 7 zeigt, dass die Elektronikeinheit 4 zwischen der Trägerschicht 2 und der Textilschicht 18 vorgesehen ist.

Die Fig. 8 zeigt, dass die Leiterbahn 11 bzw. die Zuleitung 9 eine Materialdicke 19 von 1 bis 50 µm aufweisen können. Ferner kann die Leiterbahn 11 und die Zuleitung 9 eine Breite 20 von 0,1 bis 8 mm aufweisen.

Nicht näher dargestellt ist, dass auch die Messleiterbahnen 6, 7 eine Materialdicke 19 von 1 bis 50 µm und eine Breite von 0,3 bis 2 mm aufweisen können.

Nicht näher dargestellt ist, dass die Sensorgruppe 8a-8e sich über jeweils eine Länge der Baubahn 1 von wenigstens 0,2 m, insbesondere zwischen 0,5 bis 3 m erstreckt.

Fig. 7 zeigt, dass der Schichtaufbau 3 eine weitere Schicht 23 zur Ausbildung der Baubahn 1 als Dachbahn aufweist. In weiteren Ausführungsformen kann vorgesehen sein, dass die weitere Schicht 23 die Baubahn 1 als Dachfolie, Fassadendachbahn, Fassadenbahn und/oder Dampfbremse und/oder Unterdachbahn, insbesondere Unterdeck- und/oder Unterspannbahn, ausbildet.

Die weitere Schicht 23 kann als Funktionsschicht ausgebildet sein, die insbesondere dampfsperrend und/oder diffusionsdicht ausgebildet ist. Insbesondere kann die Dachbahn, wie sie in Fig. 7 dargestellt ist, als Flachdachbahn eingesetzt werden.

Fig. 7 zeigt, dass die weitere Schicht 23 an der der Elektronikeinheit 4 abgewandten Außenseite der Trägerschicht 2 angeordnet ist. Nicht dargestellt ist, dass die weitere Schicht 23 diffusionsdicht, diffusionshemmend, wasserdampfundurchlässig und/oder wasserdicht ausgebildet sein kann.

Die Breite der Trägerschicht 2 kann zwischen 1 bis 100 cm betragen.

In Fig. 12 ist dargestellt, dass die Anzahl der Teststrukturen 29 wenigstens der Anzahl der Sensorgruppen 8a bis 8e entspricht. In dem dargestellten Ausführungsbeispiel ist sogar jedem Feuchtesensor 5 eine eigene Teststruktur 29 zugeordnet. Dies ist insbesondere bei einem wiederkehrenden Druckbild der Elektronikeinheit 4 bzw. beim Druck der Elektronikeinheit 4 im Rapportdruck besonders vorteilhaft, da so eine individuelle Bereitstellung der Leitungseinheiten 12 sowie der Sensorgruppen 8 erfolgen kann, insbesondere sofern zuvor alle zweiten Messleiterbahnen 7 und alle Leiterbahnen 11 miteinander elektrisch verbunden gewesen sind. Dieser elektrische Verbund kann dann über die Anordnung der entsprechenden Trennstellen 13 aufgehoben worden. Die Teststrukturen 29 können dabei alle mit nur einer Leiterbahn 11 verbunden sein, wie dies die Fig. 12 zeigt. Bei einer derartigen Ausbildung wird jedoch vorausgesetzt, dass derjenige Leiterbahnabschnitt, mit dem die Teststruktur 29 verbunden ist, zumindest mit dem jeweiligen Hauptleiterbahnabschnitt 14 der jeweiligen Leitungseinheit 12 elektrisch verbunden ist, was durch die Bereitstellung von entsprechenden Trennstellen 13 gewährleistet werden kann, wie ebenfalls aus der Fig. 12 ersichtlich wird.

Ferner zeigt die Fig. 12, dass die Kontakt-Leiterbahn 31 des jeweiligen Feuchtesensors 5 durch die Leitungseinheit 12 der jeweiligen Sensorgruppe 8a bis 8e des Feuchtesensors 5 gebildet ist, insbesondere wird die Kontakt-Leiterbahn 31 durch den Hauptleiterbahnabschnitt 14 der der Sensorgruppe 8a bis 8e zugeordneten Leitungseinheit 12 und bedarfsweise vorgesehenen Nebenleiterbahnabschnitten 15 gebildet. Dies ist entsprechend in der Fig. 12 gezeigt. Die Fig. 12 zeigt, dass jede Teststruktur jeweils mit der der Sensorgruppe zugeordneten Leitungseinheit, die sich aus mehreren Leiterbahnabschnitten zusammensetzen kann, elektrisch verbunden ist. Die Kontakt-Leiterbahn 31 kann als Bestandteil der Leitungseinheit 12 der jeweiligen Sensorgruppe 8a bis 8e ausgebildet sein.

Fig. 13 zeigt, dass die Teststruktur 29 unmittelbar mit der Zuleitung 9 und der zu der Zuleitung 9 am nächsten liegenden Leiterbahn 11, insbesondere dem am nächsten liegenden Leiterbahnabschnitt, wie dies die Fig. 13 zeigt, elektrisch verbunden ist.

Die Fig. 13 zeigt, dass der zu der Zuleitung 9 am nächsten liegende Leiterbahnabschnitt der Hauptleiterbahnabschnitt 14 ist. In Fig. 12 ist dargestellt, dass in Abhängigkeit der jeweiligen Sensorgruppe 8a bis 8e unterschiedliche Leiterbahnabschnitte den zu der Zuleitung 9 am nächsten liegenden Leiterbahnabschnitt bilden. So ist dies für die Sensorgruppe 8a der Hauptleiterbahnabschnitt 14 der ersten Leiterbahn 11, für die Sensorgruppen 8b bis 8e jedoch der Nebenleiterbahnabschnitt 15, der zu der Zuleitung 9 am nächsten angeordnet ist bzw. zu dieser den geringsten Abstand einschließt. Der nächstliegende Leiterbahnabschnitt ist als Teil der Leitungseinrichtung 9 anzusehen. Die Teststruktur 29 verbindet demnach die Zuleitung 9 und den am nächsten liegenden Leiterbahnabschnitt der Leitungseinrichtung 10 elektrisch. Wenigstens eine Leiterbahn 11 kann eine Mehrzahl von Nebenleiterbahnabschnitten 15 aufweisen, wobei die Nebenleiterbahnabschnitte 15 der jeweiligen Leiterbahn 11 voneinander jeweils durch wenigstens eine bevorzugt in der Leiterbahn 11 vorgesehenen Trennstelle 13 getrennt sind. In Fig. 12 ist dargestellt, dass in Abhängigkeit der Anzahl der Sensorgruppen 8 auch die Anzahl der Nebenleiterbahnabschnitte 15 der zu der Zuleitung 9 am nächsten liegenden Leiterbahn 11 bereitgestellt wird, die Nebenleiterbahnabschnitte 15 sind somit insbesondere bestimmt durch die Anzahl der Sensorgruppen 8 minus 1.

Die Fig. 12 zeigt, dass wenigstens eine zweite Messleiterbahn eines Feuchtesensors 5 einer jeweiligen Sensorgruppe 8a bis 8e elektrisch mit dem Hauptleiterbahnabschnitt 14 der zugeordneten Leitungseinheit 12 verbunden ist und wenigstens einen Nebenleiterbahnabschnitt 15 der zugeordneten Leitungseinheit 12 kreuzt und elektrisch verbunden ist. Die zweite Messleiterbahn 7 ist von wenigstens einem Hauptleiterbahnabschnitt 14 einer anderen Leitungseinheit 12 durch wenigstens eine Trennstelle13, bevorzugt in der zweiten Messleiterbahn 7, elektrisch getrennt.

Zudem ist bei der Ausbildung der Teststrukturen 29 besonders vorteilhaft, wenn, wie in Fig. 12 gezeigt, ein Nebenleiterbahnabschnitt 15 einer Leitungseinheit 12 alle zweiten Messleiterbahnen 7 der der Leitungseinheit 12 zugeordneten Sensorgruppe 8a bis 8e kreuzt und elektrisch mit diesen verbunden ist. Dies ist für die Sensorgruppen 8b bis 8e in der Fig. 12 dargestellt. Eine solche Ausbildung ist deswegen vorteilhaft, da bei den Sensorgruppen 8b bis 8e die Teststruktur 29 die Zuleitung 9 elektrisch mit dem am nächsten liegenden Leiterbahnabschnitt verbindet, der für die Sensorgruppen 8b bis 8e der Nebenleiterbahnabschnitt 15 ist.

Durch diese entsprechende Ausbildung kann gewährleistet werden, dass trotz elektrischer Kontaktierung der Teststruktur 29 mit dem Nebenleiterbahnabschnitt die Teststruktur 29 zumindest mittelbar den Hauptleiterbahnabschnitt 14 der jeweiligen Leitungseinheit elektrisch kontaktieren kann, wodurch die Funktionsüberprüfung des Feuchtesensors 5 über die Teststruktur 29 gewährleistet werden kann. Dies gelingt, indem die Nebenleiterbahnabschnitte 15 elektrisch über die zweiten Messleiterbahnen 7 mit den Hauptleiterbahnabschnitten 14 verbunden sind.

In Fig. 14 ist eine weitere Ausführungsform einer Baubahn 1 aufweisend mehrere Teststrukturen 29 für die Feuchtesensoren 5 gezeigt. Bei der in Fig. 14 dargestellten Ausführungsform weisen die Sensorgruppen 8 nur je einen Feuchtesensor 5 auf. Auch bei dieser Ausführungsform ist die Teststruktur 29 unmittelbar mit der Zuleitung 9 und dem jeweils zu der Zuleitung 9 am nächsten liegenden Leiterbahnabschnitt (entweder Hauptleiterbahnabschnitt 14 oder Nebenleiterbahnabschnitt 15) elektrisch verbunden und insbesondere elektrisch jeweils mit der der jeweiligen Sensorgruppe 8 zugeordneten Leitungseinheit 12 verbunden.

Die Leitungseinheiten 12 sind in der Fig. 12 und Fig. 14 nicht näher dargestellt, setzen sich jedoch analog wie in den Fig. 1 und den Fig. 4A bis 4E gezeigt zusammen.

### Bezugszeichenliste:

- 1: Baubahn
- 2: Trägerschicht
- 3: Außenseite von 2
- 4: Elektronikeinheit
- 5: Feuchtesensor
- 6: erste Messleiterbahn von 5
- 7: zweite Messleiterbahn von 5
- 8a: Sensorgruppe
- 8b: Sensorgruppe
- 8c: Sensorgruppe
- 8d: Sensorgruppe
- 8e: Sensorgruppe
- 9: Zuleitung
- 10: Leitungseinrichtung
- 11: Leiterbahnen von 10
- 12: Leitungseinheit
- 13: Trennstelle
- 14: Hauptleiterbahnabschnitt
- 15: Nebenleiterbahnabschnitt
- 16: externe Anschlusseinrichtung
- 17: Verbindungsmittel
- 18: Textilschicht
- 19: Materialdicke
- 20: Breite
- 21: Finger
- 22: minimaler Abstand
- 23: weitere Schicht
- 24: Schichtaufbau
- 25: zweites Verbindungsmittel
- 26: Leitungskabel
- 27: Gehäuse
- 28: Energieversorgungsmittel
- 29: Teststruktur
- 30: Trennleiterbahnabschnitt
- 31: Kontakt-Leiterbahn
- 32: Windungen
- 33: Abstand zu 5

## Patentansprüche

1. Baubahn (1), insbesondere zur Verwendung als Dachbahn, mit einer Trägerschicht (2), wobei auf der Außenseite (3) der Trägerschicht (2) eine Elektronikeinheit (4) aufweisend wenigstens einen Feuchtesensor (5) aufgebracht, insbesondere aufgedruckt, ist,
wobei der Feuchtesensor (5) zur Feuchtemessung elektrisch mit einer Zuleitung (9) und einer Kontakt-Leiterbahn (31) verbunden ist,
**dadurch gekennzeichnet,**
**dass** zur Funktionsüberprüfung der elektrischen Kontaktierung des Feuchtesensors (5) eine Teststruktur (29) vorgesehen ist, die mit der Zuleitung (9) und der Kontakt-Leiterbahn (31) elektrisch verbunden ist.

2. Baubahn nach Anspruch 1, **dadurch gekennzeichnet, dass** die Teststruktur (29) parallel zum Feuchtesensor (5) geschaltet ist und/oder
dass die Teststruktur (29) als Testleiterbahnabschnitt ausgebildet ist.

3. Baubahn nach Anspruch oder 2, **dadurch gekennzeichnet, dass** die Teststruktur (29) einen elektrischen Widerstand zwischen 0,1 bis 30 MΩ, bevorzugt zwischen 1 bis 10 MΩ, aufweist und/oder
dass die Länge des Testleiterbahnabschnittes (30) größer, insbesondere um den Faktor von wenigstens 1,1, als der lichte Abstand zwischen der Zuleitung (9) und der Kontakt-Leiterbahn (31) ist.

4. Baubahn nach einem der vorhergehenden Ansprüche, **dadurch gekennzeichnet, dass** die Teststruktur (29) eine Mehrzahl von, bevorzugt gerundeten und/oder eckigen, Windungen (32) aufweist, insbesondere mäanderförmig ausgebildet ist.

5. Baubahn nach einem der vorhergehenden Ansprüche, **dadurch gekennzeichnet, dass** der Feuchtesensor (5) als resistiver Feuchtesensor (5) mit einer ersten und einer zweiten Messleiterbahn (6, 7) zur resistiven und/oder kapazitiven Feuchtemessung ausgebildet ist, insbesondere wobei die erste Messleiterbahn (6) elektrisch mit der Zuleitung (9) und die zweite Messleiterbahn (7) elektrisch mit der Kontakt-Leiterbahn (31) verbunden ist und/oder insbesondere wobei die zwei Messleiterbahnen (6, 7) des Feuchtesensors (5) an ihren einander zugewandten Enden zur Bildung eines Sensorbereichs zumindest bereichsweise miteinander kämmen und/oder dass die wenigstens zwei Messleiterbahnen (6, 7) des Feuchtesensors (5) jeweils eine Mehrzahl von abstehenden Fingern (21) aufweisen, wobei, vorzugsweise, die Finger (21) der Messleiterbahnen (6, 7) ineinander greifen und/oder miteinander kämmen.

6. Baubahn nach einem der vorhergehenden Ansprüche, **dadurch gekennzeichnet, dass** eine Mehrzahl von Feuchtesensoren (5) vorgesehen ist, wobei die zweite Messleiterbahn (7) des jeweiligen Feuchtesensors (5) mit einer eine Mehrzahl von Leiterbahnen (11) aufweisenden Leitungseinrichtung (10) elektrisch verbunden ist.

7. Baubahn nach einem der vorhergehenden Ansprüche, **dadurch gekennzeichnet, dass** eine Mehrzahl von jeweils durch wenigstens einen Feuchtesensor (5) gebildete Sensorgruppen (8a-8e) vorgesehen ist,
wobei jeder Sensorgruppe (8a-8e) eine mit der zweiten Messleiterbahn (7) des jeweiligen Feuchtesensors (5) der jeweiligen Sensorgruppe (8a-8e) elektrisch verbundene Leitungseinheit (12) der Leitungseinrichtung (10) zugeordnet ist, wobei die einzelnen Leitungseinheiten (12) elektrisch voneinander über wenigstens eine Trennstelle (13) und/oder Trennstellen (13), insbesondere in den jeweiligen Leiterbahnen (11) und/oder in den jeweiligen zweiten Messleiterbahnen (7), getrennt sind.

8. Baubahn nach einem der vorhergehenden Ansprüche, **dadurch gekennzeichnet, dass** die Anzahl der Teststrukturen (29) wenigstens der Anzahl der Sensorgruppen (8a-8e) entspricht und/oder diese übersteigt, insbesondere wobei jedem Feuchtesensor (5) eine eigene Teststruktur (29) zugeordnet ist.

9. Baubahn nach einem der vorhergehenden Ansprüche, **dadurch gekennzeichnet, dass** die Kontakt-Leiterbahn (31) des jeweiligen Feuchtesensors (5) durch die Leitungseinheit (12) der jeweiligen Sensorgruppe (8a-8e) des Feuchtesensors (5) gebildet ist und/oder dass die Kontakt-Leiterbahn (31) als Bestandteil der Leitungseinheit (12) der jeweiligen Sensorgruppe (8a-8e) ausgebildet ist.

10. Baubahn nach einem der vorhergehenden Ansprüche, **dadurch gekennzeichnet, dass** wenigstens eine Leiterbahn (11) einen mit einer elektrischen Verbindungseinrichtung der Baubahn (1) verbindbaren Hauptleiterbahnabschnitt (14) und wenigstens einen von dem Hauptleiterbahnabschnitt (14) dieser Leiterbahn (11) über eine Trennstelle (13) getrennten Nebenleiterbahnabschnitt (15) aufweist.

11. Baubahn nach einem der vorhergehenden Ansprüche, **dadurch gekennzeichnet, dass** die Teststruktur (29) unmittelbar mit der Zuleitung (9) und der zu der Zuleitung (9) am nächsten angeordneten Leiterbahn (11), insbesondere dem am nächsten liegenden Leiterbahnabschnitt, insbesondere Hauptleiterbahnabschnitt (14) und/oder Nebenleiterbahnabschnitt (15), der Leitungseinrichtung (10) elektrisch verbunden ist, insbesondere wobei wenigstens eine Leiterbahn (11) eine Mehrzahl von Nebenleiterbahnabschnitten (15) aufweist, wobei die Nebenleiterbahnabschnitte (15) der jeweiligen Leiterbahnen (11) voneinander jeweils durch wenigstens eine, bevorzugt in der Leiterbahn (11) vorgesehene, Trennstelle (13) getrennt sind.

12. Baubahn nach einem der vorhergehenden Ansprüche, **dadurch gekennzeichnet, dass** wenigstens einer Leitungseinheit (12) ein Hauptleiterbahnabschnitt (14) einer Leiterbahn (11) und wenigstens ein Nebenleiterbahnabschnitt (15) wenigstens einer anderen Leiterbahn (11) zugeordnet ist.

13. Baubahn nach einem der vorhergehenden Ansprüche, **dadurch gekennzeichnet, dass** wenigstens eine zweite Messleiterbahn (7) eines Feuchtesensor (5) einer jeweiligen Sensorgruppe (8a-8e) elektrisch mit dem Hauptleiterbahnabschnitt (14) der zugeordneten Leitungseinheit (12) verbunden ist und wenigstens einen Nebenleiterbahnabschnitt (15) der zugeordneten Leitungseinheit (12) kreuzt und elektrisch verbunden ist, wobei die zweite Messleiterbahn (7) von wenigstens einem Hauptleiterbahnabschnitt (14) einer anderen Leitungseinheit (12) durch wenigstens eine Trennstelle (13), bevorzugt in der zweiten Messleiterbahn (7), elektrisch getrennt ist.

14. Baubahn nach einem der vorhergehenden Ansprüche, **dadurch gekennzeichnet, dass** ein Nebenleiterbahnabschnitt (15) einer Leitungseinheit (12) alle zweiten Messleiterbahnen (7) der der Leitungseinheit (12) zugeordneten Sensorgruppe (8a-8e) kreuzt und elektrisch mit diesen verbunden ist.

15. Baubahn nach einem der vorhergehenden Ansprüche, **dadurch gekennzeichnet, dass** die Zuleitung (9), die Teststruktur (29), die Leitungseinrichtung (10) und/oder die Leiterbahnen (11) der Leitungseinrichtung (10) auf die Außenseite (3) der Trägerschicht (2) aufgebracht, insbesondere aufgedruckt, ist/sind.
